# EUROPEAN PATENT APPLICATION

(11) **EP 4 346 348 A1**
(43) Date of publication of application: **03.04.2024**
(21) Application number: 23191967.1
(22) Date of filing: 17.08.2023
(51) Int. Cl.: H10B 12/00, H01L 29/786

(54) **SEMICONDUCTOR MEMORY DEVICE AND METHOD FOR MANUFACTURING THE SAME**

(30) Priority: 29.09.2022 KR 20220124094
(71) Applicant: Samsung Electronics Co., Ltd., Suwon-si, Gyeonggi-do 16677 (KR)
(72) Inventor: NA, Jae Won, 16677 Suwon-si (KR); KIM, Chang Sik, 16677 Suwon-si (KR); SONG, Jun Hwa, 16677 Suwon-si (KR); JUN, Ji Hee, 16677 Suwon-si (KR)
(74) Representative: Marks & Clerk LLP

(57) **Abstract**

A semiconductor memory device includes a substrate; a bit-line on the substrate and extending in a first direction; first and second channel patterns on the bit-line; the second channel pattern being spaced apart from the first channel pattern in the first direction; a first word-line between the first and second channel patterns and extending in a second direction that intersects the first direction; a second word-line between the first and second channel patterns, extending in the second direction, and being spaced apart from the first word-line in the first direction; capacitors on and connected to the channel patterns; wherein the first and second channel patterns include first and second metal oxide patterns sequentially on the bit-line, each of the first and second metal oxide patterns include an amorphous metal oxide, and a composition of the first metal oxide pattern is different from a composition of the second metal oxide pattern.

## Description

### BACKGROUND

### 1. Field

Embodiments relate to a semiconductor memory device and a method for manufacturing the same.

### 2. Description of the Related Art

In order to meet high performance and low price of a product as demanded by consumers, an integration density of a semiconductor memory device constituting the product may be increased. The integration density of the semiconductor memory device may be an important factor in determining a price of the product. Thus, the semiconductor memory device may have an increased integration density.

An integration density of a two-dimensional or planar semiconductor memory device may be determined based on an area occupied by a unit memory cell, and may be affected by a technical level of a micro-pattern formation scheme.

### SUMMARY

The embodiments may be realized by providing a semiconductor memory device including a substrate; a bit-line on the substrate, the bit-line extending in a first direction; a first channel pattern on the bit-line; a second channel pattern on the bit-line and spaced apart from the first channel pattern in the first direction; a first word-line between the first channel pattern and the second channel pattern and extending in a second direction that intersects the first direction; a second word-line between the first channel pattern and the second channel pattern, the second word-line extending in the second direction and being spaced apart from the first word-line in the first direction; a first capacitor on and connected to the first channel pattern; and a second capacitor on and connected to the second channel pattern, wherein the first channel pattern and the second channel pattern each include a first metal oxide pattern and a second metal oxide pattern sequentially on the bit-line, each of the first metal oxide pattern and the second metal oxide pattern includes an amorphous metal oxide, and a composition of the first metal oxide pattern is different from a composition of the second metal oxide pattern.

The embodiments may be realized by providing a semiconductor memory device including a substrate; a bit-line on the substrate, the bit-line extending in a first direction; a first channel pattern on the bit-line; a second channel pattern on the bit-line and spaced apart from the first channel pattern in the first direction; a first word-line between the first channel pattern and the second channel pattern and extending in a second direction that intersects the first direction; a second word-line between the first channel pattern and the second channel pattern, the second word-line extending in the second direction and being spaced apart from the first word-line in the first direction; a first capacitor on and connected to the first channel pattern; and a second capacitor on and connected to the second channel pattern, wherein the first channel pattern and the second channel pattern each include a first metal oxide pattern and a second metal oxide pattern, the first metal oxide pattern includes an amorphous metal oxide, and the second metal oxide pattern includes CAAC (c-axis aligned crystalline) IGZO (indium gallium zinc oxide).

The embodiments may be realized by providing a semiconductor memory device including a substrate; a peripheral gate structure on the substrate; a bit-line on the peripheral gate structure and extending in a first direction; a channel structure on the bit-line and including a horizontal portion, a first vertical portion, and a second vertical portion protruding from the horizontal portion; a first word-line on the channel structure and extending in a second direction that intersects the first direction; a second word-line on the channel structure, the second word-line extending in the second direction and being spaced apart from the first word-line in the first direction; a gate isolation pattern on the horizontal portion of the channel structure and separating the first word-line and the second word-line; a first capacitor on the channel structure, the first capacitor being connected to the first vertical portion of the channel structure; and a second capacitor on the channel structure, the second capacitor being connected to the second vertical portion of the channel structure, wherein the channel structure includes a first metal oxide pattern in contact with the bit-line, and a second metal oxide pattern on the first metal oxide pattern, the first metal oxide pattern includes gallium-rich (Ga-rich) IGZO, and the second metal oxide pattern includes indium-rich (In-rich) IGZO.

The embodiments may be realized by providing a method for manufacturing a semiconductor memory device, the method including forming a bit-line on a substrate such that the bit-line extends in a first direction; forming a protruding insulating pattern on the substrate such that the protruding insulating pattern includes a channel trench exposing the bit-line and extends in a second direction that intersects the first direction; forming a channel structure extending along a lower surface and a sidewall of the channel trench; forming a first word-line and a second word-line on the channel structure such that the first word-line and the second word-line extend in the second direction along the sidewall of the channel trench and are spaced apart from each other in the first direction; forming a gate isolation pattern on the first word-line and the second word-line and filling the channel trench; and forming a capacitor on the gate isolation pattern such that the capacitor is connected to the channel structure, wherein the channel structure includes a first metal oxide pattern and a second metal oxide pattern sequentially on the bit-line, each of the first metal oxide pattern and the second metal oxide pattern includes an amorphous metal oxide, and a composition of the first metal oxide pattern is different from a composition of the second metal oxide pattern.

At least some of the above and other features of the invention are set out in the claims.

### BRIEF DESCRIPTION OF DRAWINGS

Features will be apparent to those of skill in the art by describing in detail example embodiments with reference to the attached drawings in which:
FIG. 1 is a layout diagram for illustrating a semiconductor memory device according to some embodiments.
FIG. 2 is a cross-sectional view taken along A - A and B - B of FIG. 1.
FIG. 3 is a cross-sectional view taken along C - C and D - D of FIG. 1.
FIGS. 4 to 8 are enlarged views of a region P of FIG. 2, respectively.
FIG. 9 is a diagram for illustrating a semiconductor memory device according to some embodiments.
FIG. 10 is a diagram for illustrating a semiconductor memory device according to some embodiments.
FIGS 11 and 12 are diagrams for illustrating a semiconductor memory device according to some embodiments.
FIGS. 13 to 16 are diagrams for illustrating a semiconductor memory device according to some embodiments.
FIGS. 17 to 20 are diagrams for illustrating semiconductor memory devices according to some embodiments, respectively.
FIGS. 21 to 37 are diagrams for illustrating stages in a method for manufacturing a semiconductor memory device according to some embodiments.

### DETAILED DESCRIPTION

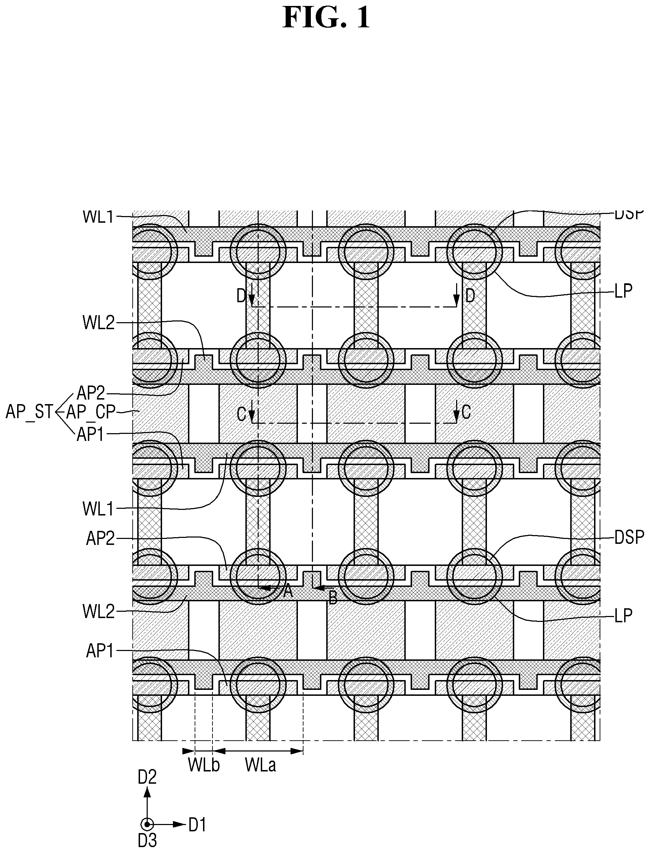

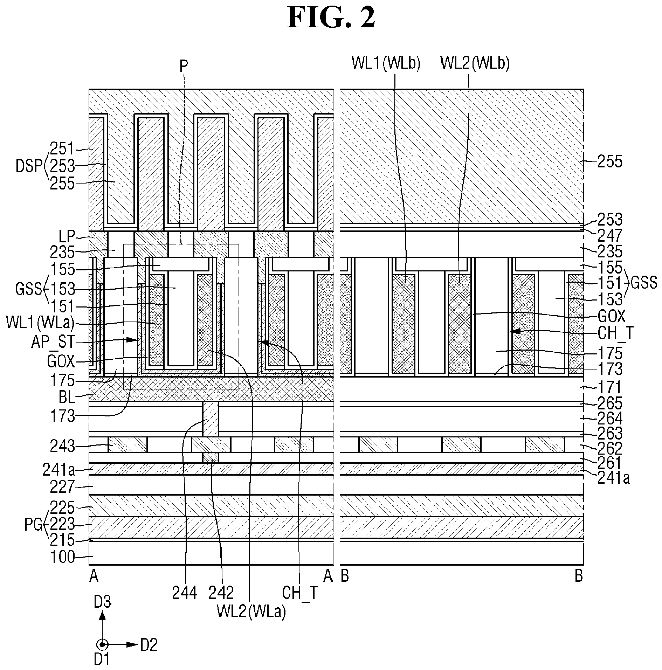

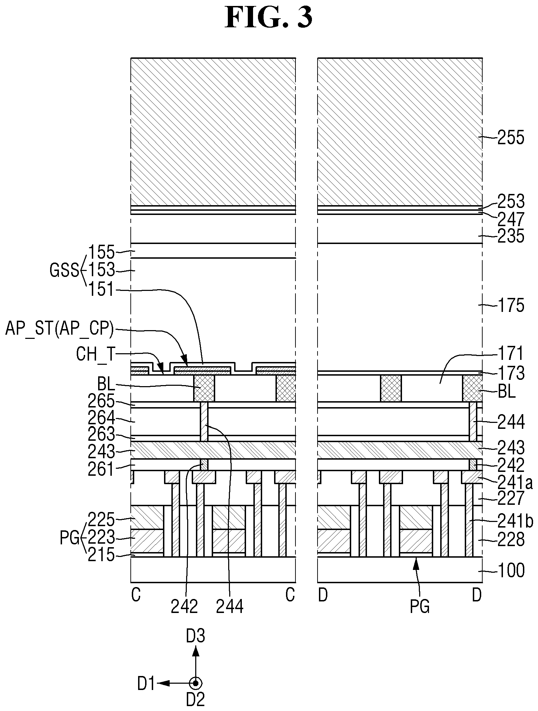

FIG. 1 is a layout diagram for illustrating a semiconductor memory device according to some embodiments. FIG. 2 is a cross-sectional view taken along A - A and B - B of FIG. 1. FIG. 3 is a cross-sectional view taken along C - C and D - D of FIG. 1.

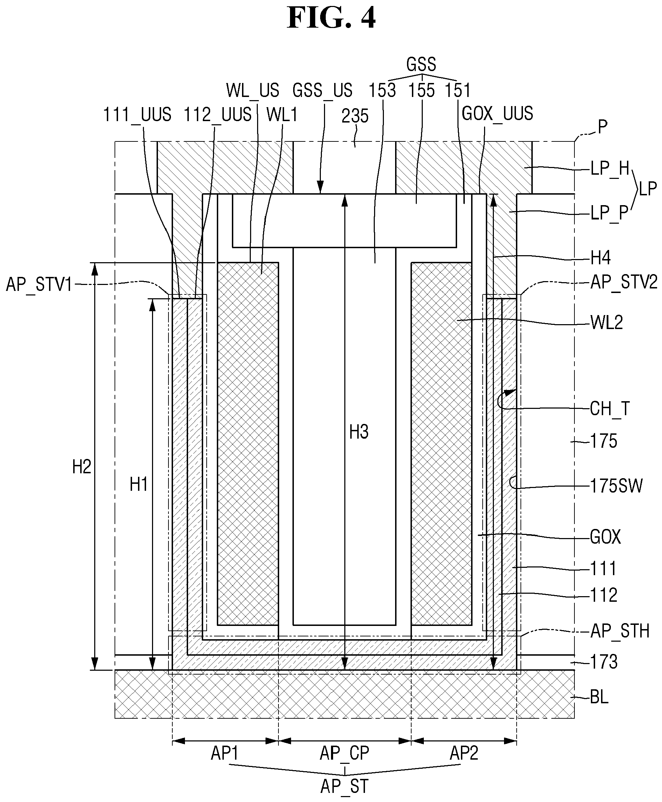

FIGS. 4 to 8 are enlarged views of a region P of FIG. 2, respectively.

A semiconductor memory device according to embodiments of the present disclosure may include memory cells including a vertical channel transistor (VCT).

Referring to FIG. 1 to FIG. 8, the semiconductor memory device according to some embodiments may include a peripheral gate structure PG, bit-lines BL, word-lines WL1 and WL2, channel structures AP_ST, a protruding insulating pattern 175, and information storage patterns DSP, all of which may be formed on a substrate 100.

The substrate 100 may be embodied as a silicon substrate, or may include a material other than silicon, e.g., silicon germanium, indium antimonide, a lead telluride compound, indium arsenide, indium phosphide, gallium arsenide, or gallium antimonide. As used herein, the term "or" is not an exclusive term, e.g., "A or B" would include A, B, or A and B.

The peripheral gate structure PG may be on the substrate 100. The substrate 100 may include a cell array area and a peripheral circuit area. The peripheral gate structure PG may be across the cell array area and the peripheral circuit area. In an implementation, a portion of the peripheral gate structure PG may be on the cell array area of the substrate 100, and the remainder of the peripheral gate structure PG may be on the peripheral circuit area of the substrate 100.

The peripheral gate structure PG may be included in a sensing transistor, a transfer transistor, and a driving transistor. In an implementation, a type of a transistor on the cell array area and the peripheral circuit area may vary depending on a design arrangement of the semiconductor memory device.

The peripheral gate structure PG may include a peripheral gate insulating film 215, a peripheral lower conductive pattern 223, and a peripheral upper conductive pattern 225. The peripheral gate insulating film 215 may include a silicon oxide film, a silicon oxynitride film, a high dielectric constant insulating film having a higher dielectric constant than that of a silicon oxide film, or a combination thereof. The high dielectric constant insulating film may include, e.g., a metal oxide, a metal oxynitride, a metal silicon oxide, or a metal silicon oxynitride.

Each of the peripheral lower conductive pattern 223 and the peripheral upper conductive pattern 225 may include a conductive material. In an implementation, each of the peripheral lower conductive pattern 223 and the peripheral upper conductive pattern 225 may include a doped semiconductor material, a conductive metal nitride, a conductive metal silicon nitride, a metal carbonitride, a conductive metal silicide, a conductive metal oxide, a two-dimensional (2D) material, a metal, or a metal alloy. The peripheral gate structure PG is illustrated as including a plurality of conductive patterns.

In the semiconductor memory device according to some embodiments, the two-dimensional material may be a metallic material or a semiconductor material. The two-dimensional material may include two-dimensional allotrope or two-dimensional compound. In an implementation, the two-dimensional material may include, e.g., graphene, molybdenum disulfide (MoS₂), molybdenum diselenide (MoSe₂), tungsten diselenide (WSe₂), or tungsten disulfide (WS₂).

A first peripheral lower insulating film 227 and a second peripheral lower insulating film 228 may be on the substrate 100. Each of the first peripheral lower insulating film 227 and the second peripheral lower insulating film 228 may be made of an insulating material.

A first peripheral wiring line 241a and a peripheral contact plug 241b may be provided in the first peripheral lower insulating film 227 and the second peripheral lower insulating film 228. In an implementation, the first peripheral wiring line 241a and the peripheral contact plug 241b may be different layers. In an implementation, a boundary between the first peripheral wiring line 241a and the peripheral contact plug 241b may not be distinguished. Each of the first peripheral wiring line 241a and the peripheral contact plug 241b may include a conductive material.

A first peripheral upper insulating film 261 and a second peripheral upper insulating film 262 may be on the first peripheral wiring line 241a and the peripheral contact plug 241b. Each of the first peripheral upper insulating film 261 and the second peripheral upper insulating film 262 may be made of an insulating material.

A second peripheral wiring line 243 and a peripheral via plug 242 may be on the first peripheral wiring line 241a. The peripheral via plug 242 may be in the first peripheral upper insulating film 261. The second peripheral wiring line 243 may be in the second peripheral upper insulating film 262.

The second peripheral wiring line 243 and the peripheral via plug 242 may be connected to the first peripheral wiring line 241a. The peripheral via plug 242 may connect the first peripheral wiring line 241a and the second peripheral wiring line 243. Each of the second peripheral wiring line 243 and the peripheral via plug 242 may include a conductive material. In an implementation, as illustrated in the drawings, the second peripheral wiring line 243 and the peripheral via plug 242 may be provided in different layers. In an implementation, a boundary between the second peripheral wiring line 243 and the peripheral via plug 242 may not be distinguished.

A third peripheral upper insulating film 263, a fourth peripheral upper insulating film 264, and a fifth peripheral upper insulating film 265 may be sequentially provided on the second peripheral wiring line 243. Each of the third peripheral upper insulating film 263, the fourth peripheral upper insulating film 264, and the fifth peripheral upper insulating film 265 may be made of an insulating material.

The fourth peripheral upper insulating film 264 may be made of an insulating material different from a material of each of the third peripheral upper insulating film 263 and the fifth peripheral upper insulating film 265. In an implementation, the fourth peripheral upper insulating film 264 may be made of or include an oxide insulating material, and each of the third peripheral upper insulating film 263 and the fifth peripheral upper insulating film 265 may be made of or include a nitride insulating material.

A cell connection plug 244 may be formed in the third peripheral upper insulating film 263, the fourth peripheral upper insulating film 264, and the fifth peripheral upper insulating film 265. The cell connection plug 244 may be connected to the second peripheral wiring line 243. The cell connection plug 244 includes a conductive material. In an implementation, the cell connection plug 244 may be formed in a peripheral upper insulating film constituted as a single film.

The bit-lines BL may be on the peripheral gate structure PG. In an implementation, the bit-lines BL may be on the fifth peripheral upper insulating film 265. In an implementation, the bit-lines BL may contact (e.g., directly contact) the fifth peripheral upper insulating film 265.

The bit-lines BL may extend (e.g., lengthwise) in a second direction D2. Adjacent bit-lines BL may be spaced apart from each other in a first direction D1. The bit-lines BL may include a long side wall extending in the second direction D2 and a short side wall extending in the first direction D1.

In an implementation, each bit-line BL may extend from the cell array area to the peripheral circuit area. An end of each bit-line BL may be on the peripheral circuit area of the substrate 100.

Each bit-line BL may be on a cell connection plug 244. Each bit-line BL may be connected to a cell connection plug 244. Each bit-line BL may include, e.g., a doped semiconductor material, a conductive metal nitride, a conductive metal silicon nitride, a metal carbonitride, a conductive metal silicide, a conductive metal oxide, a two-dimensional material, a metal, or a metal alloy. In an implementation, as illustrated in the drawings, each bit-line BL may be embodied as a single film.

A cell lower insulating film 171 may be on the fifth peripheral upper insulating film 265. The cell lower insulating film 171 may be between the bit-lines BL spaced from each other in the first direction D1. The cell lower insulating film 171 may be made of an insulating material.

The protruding insulating pattern 175 may be on the bit-lines BL and the cell lower insulating film 171. A cell lower etch stop film 173 may be between the protruding insulating pattern 175 and the cell lower insulating film 171. Each of the protruding insulating pattern 175 and the cell lower etch stop film 173 may be made of an insulating material. The cell lower etch stop film 173 may include a material having an etch selectivity with respect to the protruding insulating pattern 175. In an implementation, the protruding insulating pattern 175 may be made of an oxide insulating material. In an implementation, the cell lower etch stop film 173 may not be between the protruding insulating pattern 175 and the cell lower insulating film 171.

The protruding insulating pattern 175 may include a plurality of channel trenches CH_T. Each channel trench CH_T may extend in an elongate manner in the first direction D1. Adjacent channel trenches CH_T may be spaced apart from each other in the second direction D2.

Each channel trench CH_T may intersect the bit-lines BL. One channel trench CH_T may expose a plurality of bit-lines BL adjacent to each other in the first direction D1.

A lower surface of each channel trench CH_T may be defined by the bit-lines BL and the cell lower insulating film 171. A sidewall of each channel trench CH_T may be defined by the protruding insulating pattern 175 and the cell lower etch stop film 173. At least a portion of the sidewall of the channel trench CH_T may be a sidewall 175SW of the protruding insulating pattern. In an implementation, when the cell lower etch stop film 173 is not included, the sidewall of each channel trench CH_T may be defined by the protruding insulating pattern 175.

The channel structure AP_ST may be on each bit-line BL. A plurality of the channel structures AP_ST may be connected to one bit-line BL. The plurality of channel structures AP_ST on one bit-line BL may be spaced apart from each other in the second direction D2.

The channel structure AP_ST may be in the channel trench CH_T extending in the first direction D1. The plurality of channel structures AP_ST may be in one channel trench CH_T. The plurality of channel structures AP_ST in the channel trench CH_T may be spaced apart from each other in the first direction D1.

In an implementation, the channel structures AP_ST may be two-dimensionally arranged along the first direction D1 and the second direction D2 intersecting each other.

The channel structure AP_ST may extend along a sidewall and a lower surface of the channel trench CH_T. In a cross-sectional view as cut in the second direction D2, the channel structure AP_ST may have a "U" shape.

The channel structure AP_ST may include a horizontal portion AP_STH, a first vertical portion AP_STV1, and a second vertical portion AP_STV2. The first vertical portion AP_STV1 of the channel structure and the second vertical portion AP_STV2 of the channel structure may protrude from the horizontal portion AP_STH of the channel structure in the third (e.g., vertical) direction D3.

The horizontal portion AP_STH of the channel structure may extend along a lower surface of the channel trench CH_T. In the cross-sectional view as cut in the second direction D2, the horizontal portion AP_STH of the channel structure may extend along an upper surface of the bit-line BL. The horizontal portion AP_STH of the channel structure may be connected to the bit-line BL. In an implementation, the horizontal portion AP_STH of the channel structure may contact the upper surface of the bit-line BL.

Each of the first vertical portion AP_STV1 of the channel structure and the second vertical portion AP_STV2 of the channel structure may extend along a sidewall of the channel trench CH_T. In the cross-sectional view as cut in the second direction D2, each of the first vertical portion AP_STV1 of the channel structure and the second vertical portion AP_STV2 of the channel structure may extend along a sidewall 175SW of the protruding insulating pattern.

The channel structure AP_ST may include an oxide semiconductor material. In an implementation, the channel structure AP_ST may include a first metal oxide pattern 111 and a second metal oxide pattern 112 sequentially on the bit-line BL. The first metal oxide pattern 111 may be between the bit-line BL and the second metal oxide pattern 112.

The first metal oxide pattern 111 may extend along a lower surface and a sidewall of the channel trench CH_T. The first metal oxide pattern 111 may be in contact with the bit-line BL.

The second metal oxide pattern 112 may be on the first metal oxide pattern 111. The second metal oxide pattern 112 may extend along the lower surface and the sidewall of the channel trench CH_T.

Each of the first metal oxide pattern 111 and the second metal oxide pattern 112 may include an oxide semiconductor material.

In the semiconductor memory device according to some embodiments, each of the first metal oxide pattern 111 and the second metal oxide pattern 112 may include an amorphous metal oxide. Each of the first metal oxide pattern 111 and the second metal oxide pattern 112 may include, e.g., IGZO (indium gallium zinc oxide), indium zinc oxide (IZO) doped with impurities, indium oxide (InO), zinc oxide (ZnO), gallium oxide (GaO), tin oxide (SnO), aluminum zinc oxide (AZO), or indium tin oxide (ITO). In the IZO (indium zinc oxide) doped with impurities, the doped impurities may include, e.g., magnesium (Mg), strontium (Sr), barium (Ba), scandium (Sc), yttrium (Y), lanthanum (La), titanium (Ti), zirconium (Zr), hafnium (Hf), aluminum (Al), tin (Sn), or tantalum (Ta). In an implementation, a composition of the first metal oxide pattern 111 may be different from a composition of the second metal oxide pattern 112.

In an implementation, the first metal oxide pattern 111 and the second metal oxide pattern 112 may include different materials. The composition of the first metal oxide pattern 111 may be different from that of the second metal oxide pattern 112.

In an implementation, the first metal oxide pattern 111 and the second metal oxide pattern 112 may include the same material (e.g., materials including the same elements). In an implementation, the first metal oxide pattern 111 and the second metal oxide pattern 112 may include IGZO (indium gallium zinc oxide, InₓGa_{y}Zn_{z}O). In an implementation, a composition ratio of indium (In), gallium (Ga), and zinc (Zn) included in the IGZO of the first metal oxide pattern 111 may be different from that of the second metal oxide pattern 112. In this case, the composition of the first metal oxide pattern 111 may be different from the composition of the second metal oxide pattern 112. A ratio x/y of a content of indium (In) to a content of gallium (Ga) in the first metal oxide pattern 111 may be different from a ratio x/y of a content of indium (In) to a content of gallium (Ga) in the second metal oxide pattern 112. In an implementation, the ratio x/y of a content of indium (In) to a content of gallium (Ga) in the first metal oxide pattern 111 may be smaller than the ratio x/y of a content of indium (In) to a content of gallium (Ga) in the second metal oxide pattern 112. The IGZO (indium gallium zinc oxide) included in the first metal oxide pattern 111 may be Ga-rich IGZO or IGZO (In:Ga:Zn)=1:1:1, and the IGZO (indium gallium zinc oxide) included in the second metal oxide pattern 112 may be In-rich IGZO or IGZO (In: Ga:Zn=1: 1: 1). IGZO (In:Ga:Zn=1:1:1) may include indium, gallium and zinc at the same content. The Ga-rich IGZO may have a higher content of gallium than a content of gallium in IGZO (In:Ga:Zn=1:1 :1), and may have a lower content of indium than a content of indium in IGZO (In:Ga:Zn=1:1:1). The In-rich IGZO may have a higher content of indium than a content of indium in IGZO (In:Ga:Zn=1:1:1), and a lower content of gallium than a content of gallium in IGZO (In:Ga:Zn=1:1:1).

The above description has been made based on IGZO. In an implementation, when each of the first metal oxide pattern 111 and the second metal oxide pattern 112 includes a metal oxide composed of at least three elements, the above description may be applied thereto.

In an implementation, each of the first metal oxide pattern 111 and the second metal oxide pattern 112 may include IZO (indium zinc oxide) doped with impurities. The impurities doped into the IZO (indium zinc oxide) in the first metal oxide pattern 111 may be different from the impurities doped into the IZO (indium zinc oxide) in the second metal oxide pattern 112. In this case, the composition of the first metal oxide pattern 111 may be different from the composition of the second metal oxide pattern 112.

In the semiconductor memory device according to some embodiments, one of the first metal oxide pattern 111 and the second metal oxide pattern 112 may include an amorphous metal oxide, and the other thereof may include CAAC (c-axis aligned crystalline) IGZO.

In an implementation, the first metal oxide pattern 111 may include the amorphous metal oxide, and the second metal oxide pattern 112 may include the CAAC IGZO. In an implementation, the first metal oxide pattern 111 may include the CAAC IGZO, and the second metal oxide pattern 112 may include the amorphous metal oxide. The amorphous metal oxide may include, e.g., IGZO (indium gallium zinc oxide), impurity-doped IZO (indium zinc oxide), InO (indium oxide), ZnO (zinc oxide), GaO (gallium oxide), SnO (tin oxide), AZO (aluminum zinc oxide), or ITO (indium tin oxide).

In an implementation, the composition of the first metal oxide pattern 111 may be different from the composition of the second metal oxide pattern 112. In an implementation, the amorphous metal oxide may include IGZO (indium gallium zinc oxide), and the composition of the first metal oxide pattern 111 may be the same as that of the second metal oxide pattern 112.

The channel structure AP_ST may include a first channel pattern AP1, a second channel pattern AP2, and a connection channel pattern AP_CP. The connection channel pattern AP_CP may connect the first channel pattern AP1 and the second channel pattern AP2. The first channel pattern AP1 and the second channel pattern AP2 may be spaced apart from each other in the second direction D2.

The first channel pattern AP1, the second channel pattern AP2, and the connection channel pattern AP_CP may be on the bit-line BL. The first channel pattern AP1 and the second channel pattern AP2 may be connected to the bit-line BL. The first channel pattern AP1 and the second channel pattern AP2 may contact an upper surface of the bit-line BL.

The first channel pattern AP1 may include a portion of the horizontal portion AP_STH of the channel structure, and the first vertical portion AP_STV1 of the channel structure. The portion of the horizontal portion AP_STH of the channel structure may be a horizontal portion of the first channel pattern AP1. The first vertical portion AP_STV1 of the channel structure may be a vertical portion of the first channel pattern AP1.

The second channel pattern AP2 may include another portion of the horizontal portion AP_STH of the channel structure and the second vertical portion AP_STV2 of the channel structure. The aforementioned other portion of the horizontal portion AP_STH of the channel structure may be a horizontal portion of the second channel pattern AP2. The second vertical portion AP_STV2 of the channel structure may be a vertical portion of the second channel pattern AP2.

The connection channel pattern AP_CP may include the remainder, e.g., remaining portions, of the horizontal portion AP_STH of the channel structure.

Based on a first word-line WL1 and a second word-line WL2 to be described below, the first channel pattern AP1, the second channel pattern AP2, and the connection channel pattern AP_CP may be distinguished from each other. In FIG. 4, descriptions are made based on the first word-line WL1 by way of example. The first word-line WL1 may include an inner side wall facing the sidewall 175SW of the protruding insulating pattern, and an outer side wall opposite to the inner side wall thereof in the second direction D2. A boundary between the first channel pattern AP1 and the connection channel pattern AP_CP may be an extension line along which the outer side wall of the first word-line WL1 extends in the third direction D3.

In the semiconductor memory device according to some embodiments, each of the first channel pattern AP1, the second channel pattern AP2, and the connection channel pattern AP_CP may include the first metal oxide pattern 111 and the second metal oxide pattern 112.

In FIG. 4, a height (in the third direction D3) from the upper surface of the bit-line BL to an uppermost surface 111_UUS of the first metal oxide pattern 111 may be equal to a height from the upper surface of the bit-line BL to an uppermost surface 112_UUS of the second metal oxide pattern 112 (e.g., H1).

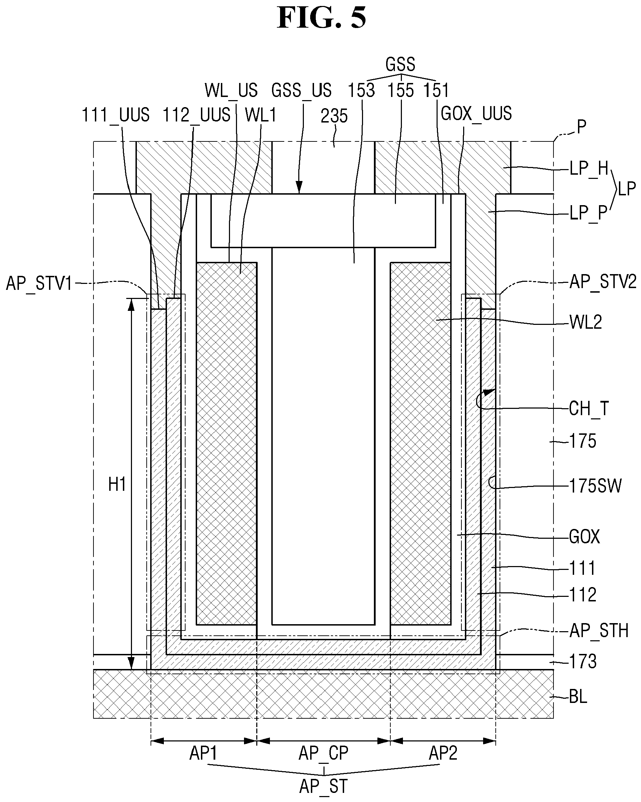

In FIG. 5, based on the upper surface of the bit line BL, the uppermost surface 111_UUS of the first metal oxide pattern 111 may be lower than (e.g., closer to the bit-line BL in the third direction D3 than) the uppermost surface 112_UUS of the second metal oxide pattern 112.

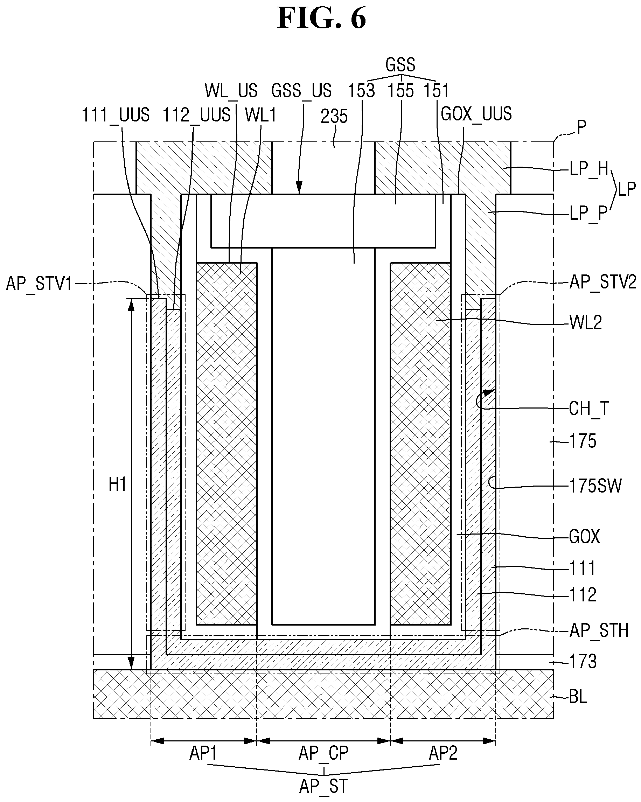

In FIG. 6, based on the upper surface of the bit-line BL, the uppermost surface 111_UUS of the first metal oxide pattern 111 may be higher than the uppermost surface 112_UUS of the second metal oxide pattern 112.

The first word-line WL1 and the second word-line WL2 may be on the channel structure AP_ST. The first word-line WL1 and the second word-line WL2 may be in the channel trench CH_T.

Each of the first word-line WL1 and the second word-line WL2 may extend in the first direction D1. The first word-lines WL1 and the second word-lines WL2 may be alternately arranged in the second direction D2. The first word-line WL1 may be spaced apart from the second word-line WL2 in the second direction D2.

The first word-line WL1 and the second word-line WL2 may be spaced apart from the bit-line BL in the third direction D3. The first word-line WL1 and the second word-line WL2 may intersect the bit-line BL.

The first word-line WL1 and the second word-line WL2 may be on the horizontal portion AP_STH of the channel structure. The first word-line WL1 and the second word-line WL2 may be between the first vertical portion AP_STV1 of the channel structure and the second vertical portion AP_STV2 of the channel structure.

The first word-line WL1 may be on the first channel pattern AP1. The second word-line WL2 may be on the second channel pattern AP2. The first word-line WL1 and the second word-line WL2 may be between the first channel pattern AP1 and the second channel pattern AP2. The first channel pattern AP1 may be closer to the first word-line WL1 than it is to the second word-line WL2 (e.g., a distance from the first channel pattern AP1 to the first word-line WL1 may be less than a distance from the first channel pattern AP1 to the second word-line WL2). The second channel pattern AP2 may be closer to the second word-line WL2 than it is to the first word-line WL1.

Each of the first word-line WL1 and the second word-line WL2 may have a width in the second direction D2. A width of a portion of the first word-line WL1 overlapping the channel structure AP_ST (e.g., in the third direction D3) may be different from a width of a portion of the first word-line WL1 that does not overlap the channel structure AP_ST in the third direction D3. A width of a portion of the second word-line WL2 overlapping the channel structure AP_ST in the third direction D3 may be different from a width of a portion of the second word-line WL2 that does not overlap the channel structure AP_ST in the third direction D3.

In an implementation shown in FIG. 2, each of the first word-line WL1 and the second word-line WL2 may include a first portion WLa and a second portion WLb. A width of the first portion WLa in the second direction D2 may be smaller than a width of the second portion WLb in the second direction D2. In an implementation, the first portion WLa may be on the channel structure AP_ST. The first portion WLa may be on the first channel pattern AP1 or on the second channel pattern AP2.

Each of the first word-line WL1 and the second word-line WL2 may include the first portions WLa and the second portions WLb alternately arranged along the first direction D1. Each of the channel structures AP_ST may be between the second portions WLb adjacent to each other in the first direction D1. In the first word-line WL1, each of the first active patterns AP1 may be between the second portions WLb of the first word-line WL adjacent to each other in the first direction D1. In the second word line WL2, each of the second active patterns AP2 may be between the second portions WLb of the second word-line WL2 adjacent to each other in the first direction D1.

The channel structure AP_ST may not be below the second portion WLb of the word-line. In an implementation, a height of the first portion WLa of the word-line may be smaller than a height of the second portion WLb of the word-line.

Each of the first and second word-lines WL1 and WL2 may include a conductive material, e.g., doped polysilicon, a conductive metal nitride, a conductive metal silicon nitride, a metal carbonitride, a conductive metal silicide, a conductive metal oxide, a two-dimensional material, a metal, or a metal alloy.

Each of the first and second word-lines WL1 and WL2 may include an upper surface WL_US and a lower surface opposite to each other in the third direction D3. The lower surface of each of the first and second word-lines WL1 and WL2 may face the bit-line BL.

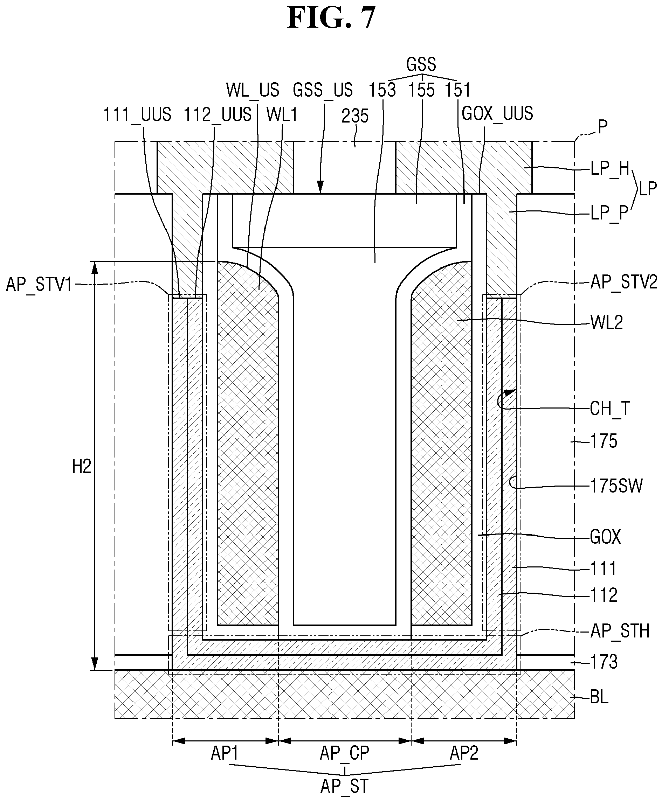

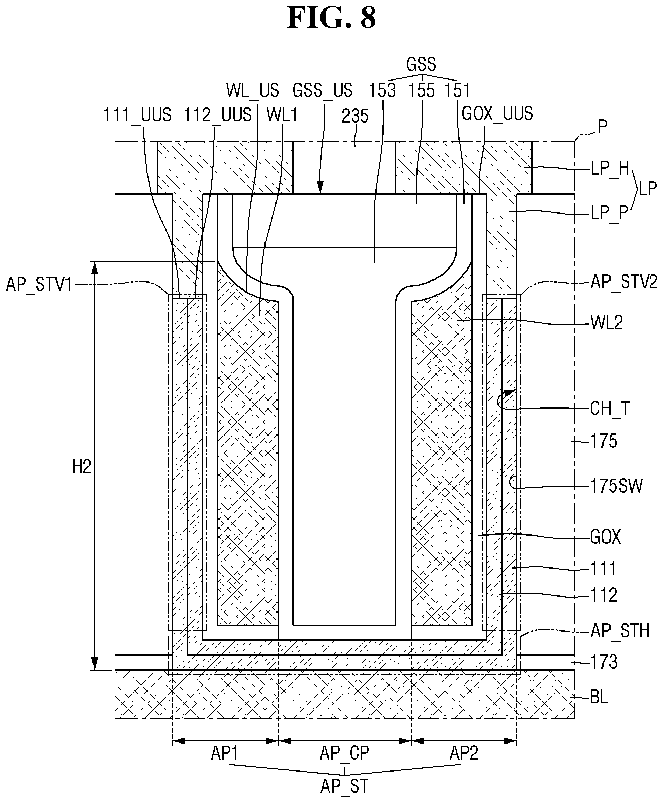

In an implementation, as illustrated in FIG. 4, the upper surface WL_US of each of the first and second word-lines WL1 and WL2 may be planar or flat. In an implementation, as illustrated in FIG. 7, the upper surface WL_US of each of the first and second word-lines WL1 and WL2 may be convexly rounded. In an implementation, as illustrated in FIG. 8, the upper surface WL_US of each of the first and second word-lines WL1 and WL2 may be concavely rounded.

Based on the upper surface of the bit-line BL, the upper surface WL_US of the first and second word lines WL1 and WL2 may be higher than the uppermost surface of vertical portions AP_STV1 and AP_STV2 of the channel structure. The uppermost surface of each of the channel patterns AP1 and AP2 may be the uppermost surface of each of the vertical portions AP_STV1 and AP_STV2 of the channel structure. A height H1 from the upper surface of the bit-line BL to the uppermost surface of each of the vertical portions AP_STV1 and AP_STV2 of the channel structure (in the third direction D3) may be smaller than a height H2 from the upper surface of the bit-line BL to the upper surface WL_US of each of the first and second word-lines WL1 and WL2.

A gate insulating film GOX may be between the first word-line WL1 and the channel structure AP_ST and between the second word-line WL2 and the channel structure AP_ST. The gate insulating film GOX may be between the first word-line WL1 and the first active pattern AP1 and between the second word-line WL2 and the second active patterns AP2. The gate insulating film GOX may extend in the first direction D1 in a parallel manner to the first word-line WL1 and the second word-line WL2.

The gate insulating film GOX may extend along the first vertical portion AP_STV1 of the channel structure. The gate insulating film GOX may extend along the second vertical portion AP_STV2 of the channel structure. In the semiconductor memory device according to some embodiments, the gate insulating film GOX may not be on a portion of the horizontal portion AP_STH of the channel structure that does not overlap with the first word-line WL1 or the second word-line WL2 in the third direction D3. In a cross-sectional view, the gate insulating film GOX between the first word-line WL1 and the channel structure AP_ST may be spaced apart from the gate insulating film GOX between the second word-line WL2 and the channel structure AP_ST.

The gate insulating film GOX may include a silicon oxide film, a silicon oxynitride film, a high dielectric constant insulating film having a higher dielectric constant than that of a silicon oxide film, or a combination thereof

A portion of the gate insulating film GOX may protrude in the third direction D3 beyond or above the upper surface WL_US of each of the first and second word-lines WL1 and WL2. A portion of the gate insulating film GOX may protrude in the third direction D3 beyond or above the uppermost surface of each of the vertical portions AP_STV1 and AP_STV2 of the channel structure.

A height H4 from the upper surface of the bit-line BL to an uppermost surface GOX_UUS of the gate insulating film (in the third direction D3) may be larger than the height H1 from the upper surface of the bit-line BL to the uppermost surface of each of the vertical portions AP_STV1 and AP_STV2 of the channel structure, as shown in FIG. 4. The height H4 from the upper surface of the bit-line BL to the uppermost surface GOX _UUS of the gate insulating film may be larger than the height H2 from the upper surface of the bit-line BL to the upper surface WL_US of each of the word-lines WL1 and WL2.

A gate isolation pattern GSS may be on the bit-line BL and the cell lower insulating film 171. The gate isolation pattern GSS may be in the channel trench CH_T. The gate isolation pattern GSS may be on the channel structure AP_ST, the first word-line WL1, and the second word-line WL2.

In the semiconductor memory device according to some embodiments, the gate isolation pattern GSS may contact the channel structure AP_ST. The gate isolation structure GSS may be on the connection channel pattern AP_CP. The gate isolation structure GSS may contact the horizontal portion AP_STH of the channel structure. The gate isolation pattern GSS may be spaced apart from the bit-line BL in the third direction D3.

The gate isolation pattern GSS may be between the first word-line WL1 and the second word-line WL2 adjacent to each other in the second direction D2. The first word-line WL1 and the second word-line WL2 may be spaced apart from each other via the gate isolation pattern GSS. The gate isolation pattern GSS may extend in the first direction D1 and may be between the first word-line WL1 and the second word-line WL2.

The first word-line WL1 may be between the gate isolation pattern GSS and the channel structure AP_ST. The second word-line WL2 may be between the gate isolation pattern GSS and the channel structure AP_ST. The first word-line WL1 may be between the gate isolation pattern GSS and the first channel pattern AP1. The second word-line WL2 may be between the gate isolation pattern GSS and the second channel pattern AP2.

The gate isolation pattern GSS may include a horizontal portion and a protruding portion. The protruding portion of the gate isolation pattern GSS may protrude from the horizontal portion of the gate isolation pattern GSS toward the bit-line BL in the third direction D3. The protruding portion of the gate isolation pattern GSS may be closer to the bit-line BL than the horizontal portion of the gate isolation pattern GSS is to the bit-line BL. The horizontal portion of the gate isolation pattern GSS may be on the upper surface WL_US of each of the first and second word-lines WL1 and WL2. In a cross-sectional view, the gate isolation pattern GSS may have a "T" shape.

The gate isolation pattern GSS may include a gate isolation liner 151, a gate isolation filling film 153, and a gate isolation capping film 155. The gate isolation liner 151 may extend along the upper surface WL_US of each of the first and second word-lines WL1 and WL2 and the outer side wall of each of the first and second word-lines WL1 and WL2. The gate isolation liner 151 may extend along the horizontal portion AP_STH of the channel structure. The gate isolation liner 151 may contact the connection channel pattern AP_CP. The gate isolation liner 151 may extend along the gate insulating film GOX protruding upwardly beyond the upper surface WL_US of each of the first and second word-lines WL1 and WL2. In an implementation, the gate isolation liner 151 may not extend along the portion of the gate insulating film GOX that protrudes upwardly beyond the upper surface WL_US of each of the first and second word-lines WL1 and WL2.

The gate isolation filling film 153 may be on the gate isolation liner 151. The gate isolation capping film 155 may be on the gate isolation filling film 153. Each of the gate isolation liner 151, the gate isolation filling film 153, and the gate isolation capping film 155 may be made of an insulating material. In an implementation, the gate isolation pattern GSS may be embodied as a single film.

In an implementation, based on the upper surface of the bit-line BL, an upper surface GSS_US of the gate isolation pattern may be at the same height as the upper surface of the protruding insulating pattern 175.

A height H3 from the upper surface of the bit-line BL to the upper surface GSS_US of the gate isolation pattern GSS (in the third direction D3) may be larger than the height H1 from the upper surface of the bit-line BL to the uppermost surface of each of the vertical portions AP_STV1 and AP_STV2 of the channel structure. The height H3 from the upper surface of the bit-line BL to the upper surface GSS_US of the gate isolation pattern may be larger than the height H2 from the upper surface of the bit-line BL to the upper surface WL_US of each of the word-lines WL1 and WL2.

In an implementation, as illustrated in the drawings, the height H3 from the upper surface of the bit-line BL to the upper surface GSS_US of the gate isolation pattern may be equal to the height H4 from the upper surface of the bit-line BL to the uppermost surface GOX _UUS of the gate insulating film.

Landing pads LP may be on the channel structure AP_ST. The landing pads LP may be connected to the first vertical portion AP_STV1 of the channel structure and the second vertical portion AP_STV2 of the channel structure.

The landing pads LP may be on the first channel pattern AP1 and the second channel pattern AP2. The landing pads LP may be connected to the first channel pattern AP1 and the second channel pattern AP2.

In a plan view, each of the landing pads LP may have one of various shapes, e.g., round, oval, rectangular, square, rhombus, or hexagonal shapes.

The landing pad LP may include a horizontal portion LP_H and a protruding portion LP_P. The horizontal portion LP_H of the landing pad may be on the upper surface of the protruding insulating pattern 175 and the upper surface GSS_US of the gate isolation pattern. The protruding portion LP_P of the landing pad may protrude from the horizontal portion LP_H of the landing pad downwardly towards the bit-line BL in the third direction D3.

Based on the upper surface of the bit-line BL, the lowermost surface of the landing pattern LP may be lower than the upper surface GSS_US of the gate isolation pattern. In an implementation, the protruding portion LP_P of the landing pad may be between the protruding insulating pattern 175 and the gate isolation pattern GSS. The height from the upper surface of the bit-line BL to the lowermost surface of the landing pattern LP may be smaller than the height H4 from the upper surface of the bit-line BL to the uppermost surface GOX _UUS of the gate insulating film.

Each of pad isolation insulating patterns 235 may be between landing pads LP. In a plan view, the landing pads LP may be arranged in a matrix form along the first direction D1 and the second direction D2. In an implementation, an upper surface of the landing pad LP may be coplanar with an upper surface of the pad isolation insulating pattern 235.

The landing pads LP include a conductive material. The landing pads LP may include, e.g., doped polysilicon, a conductive metal nitride, a conductive metal silicon nitride, a metal carbonitride, a conductive metal silicide, a conductive metal oxide, a two-dimensional material, a metal, or a metal alloy.

The data storage patterns DSP may be respectively on the landing pads LP as shown in FIG. 2. The data storage patterns DSP may be connected to the first vertical portion AP_STV1 of the channel structure and the second vertical portion AP_STV2 of the channel structure. The data storage patterns DSP may be connected to the first and second channel patterns AP1 and AP2, respectively.

The data storage patterns DSP may be arranged in a matrix form along the first direction D1 and the second direction D2, as shown in FIG. 1. Each of the data storage patterns DSP may at least partially overlap each of the landing pads LP in the third direction D3. Each of the data storage patterns DSP may contact all portions or a portion of an upper surface of each of the landing pads LP.

In an implementation, each of the data storage patterns DSP may be embodied as a capacitor. The first channel pattern AP1 may be connected to a first capacitor. The second channel pattern AP2 may be connected to a second capacitor.

Each of the data storage patterns DSP may include a capacitor dielectric layer 253 between each of storage electrodes 251 and a plate electrode 255. In this case, the storage electrode 251 may contact the landing pad LP. In a plan view, the storage electrode 251 may have one of various shapes, e.g., a round, oval, rectangular, square, rhombus, or hexagonal shapes. Each of the data storage patterns DSP may totally or partially overlap each of the landing pads LP. Each of the data storage patterns DSP may contact all portions or a portion of the upper surface of each of the landing pads LP. Each of the storage electrodes 251 may penetrate through a cell upper etch stop film 247. The cell upper etch stop film 247 may be made of an insulating material.

In an implementation, each of the data storage patterns DSP may be a variable resistance pattern that may be switched to two resistance states by an electrical pulse applied to a memory element. In an implementation, each of the data storage patterns DSP may include a phase-change material, a perovskite compound, a transition metal oxide, a magnetic material, a ferromagnetic material, an antiferromagnetic material, or a phase-change material in which a crystal state changes based on an amount of current.

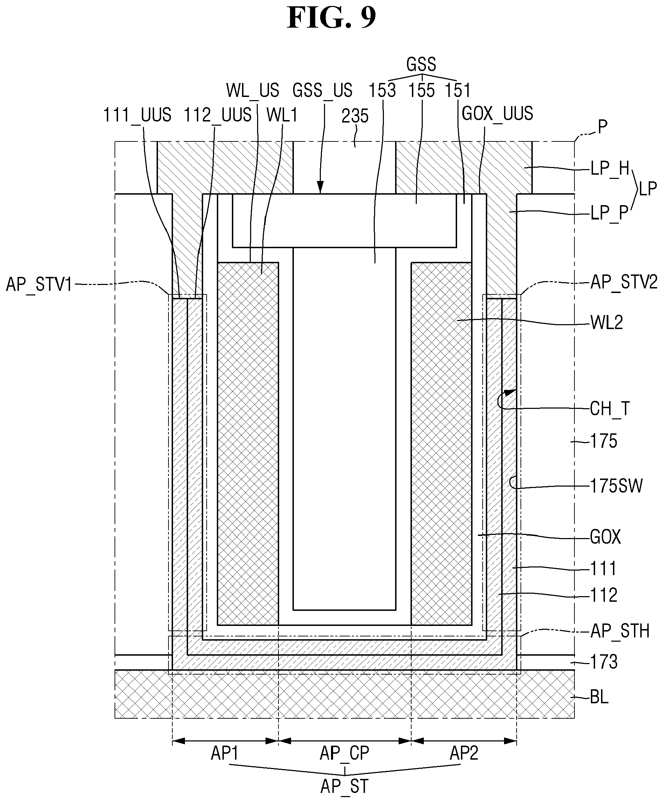

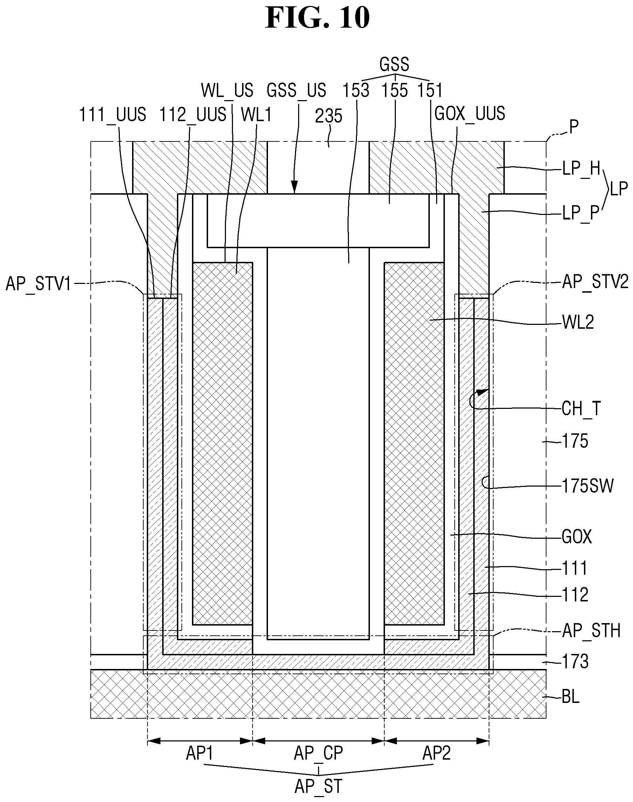

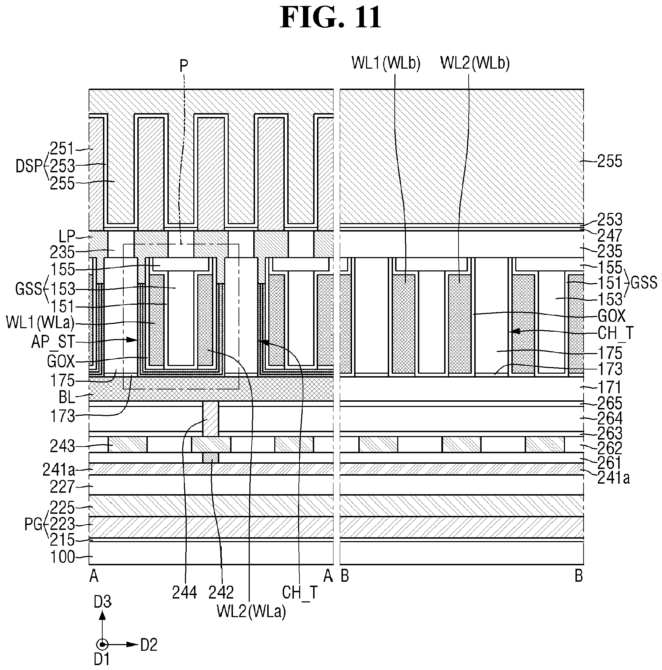

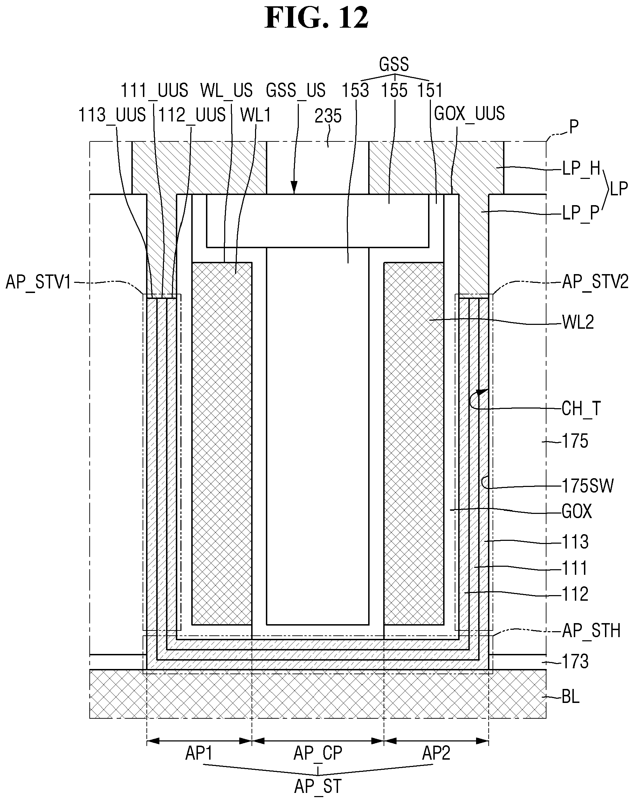

FIG. 9 is a diagram for illustrating a semiconductor memory device according to some embodiments. FIG. 10 is a diagram for illustrating a semiconductor memory device according to some embodiments. FIGS. 11 and 12 are diagrams for illustrating a semiconductor memory device according to some embodiments. For convenience of description, the following descriptions are based on differences thereof from those set forth with reference to FIG. 1 to FIG. 8.

For reference, FIG. 9 and FIG. 10 are enlarged views of a region P of FIG. 2. FIG. 11 is a cross-sectional view similar to FIG. 2, which is taken along A - A and B - B of FIG. 1. FIG. 12 is an enlarged view of the region P of FIG. 11.

Referring to FIG. 9, in the semiconductor memory device according to some embodiments, the gate isolation pattern GSS may not contact the channel structure AP_ST.

A portion of the gate insulating film GOX may be between the gate isolation pattern GSS and the channel structure AP_ST. In a cross-sectional view, a portion of the gate insulating film GOX between the first word-line WL1 and the channel structure AP_ST may be connected to a portion of the gate insulating film GOX between the second word-line WL2 and the channel structure AP_ST.

Referring to FIG. 10, in the semiconductor memory device according to some embodiments, the connection channel pattern AP_CP may include the first metal oxide pattern 111 and may not include the second metal oxide pattern 112.

A portion of the gate isolation pattern GSS may be recessed into the channel structure AP_ST. In an implementation, the gate isolation pattern GSS may contact the first metal oxide pattern 111.

Referring to FIG. 11 and FIG. 12, in the semiconductor memory device according to some embodiments, the channel structure AP_ST may further include a third metal oxide pattern 113.

The third metal oxide pattern 113 may be between the bit-line BL and the first metal oxide pattern 111. The third metal oxide pattern 113 may extend along a sidewall and a lower surface of the channel trench CH_T.

The third metal oxide pattern 113 may include an oxide semiconductor material. In an implementation, the third metal oxide pattern 113 may include an amorphous metal oxide. The third metal oxide pattern 113 may include, e.g., AZO (aluminum zinc oxide) or ITO (indium tin oxide).

A composition of the third metal oxide pattern 113 may be different from a composition of the first metal oxide pattern 111.

Each of the first channel pattern AP1, the second channel pattern AP2, and the connection channel pattern AP_CP may include the first metal oxide pattern 111, the second metal oxide pattern 112, and the third metal oxide pattern 113.

In an implementation, as illustrated in the drawings, the height from the upper surface of the bit-line BL to the uppermost surface 111_UUS of the first metal oxide pattern 111 may be equal to a height from the upper surface of the bit-line BL to an uppermost surface 113_UUS of the third metal oxide pattern 113.

In an implementation, as illustrated in the drawings, the height from the upper surface of the bit-line BL to the uppermost surface 112_UUS of the second metal oxide pattern 112 may be equal to the height from the upper surface of the bit-line BL to the uppermost surface 113 _UUS of the third metal oxide pattern 113.

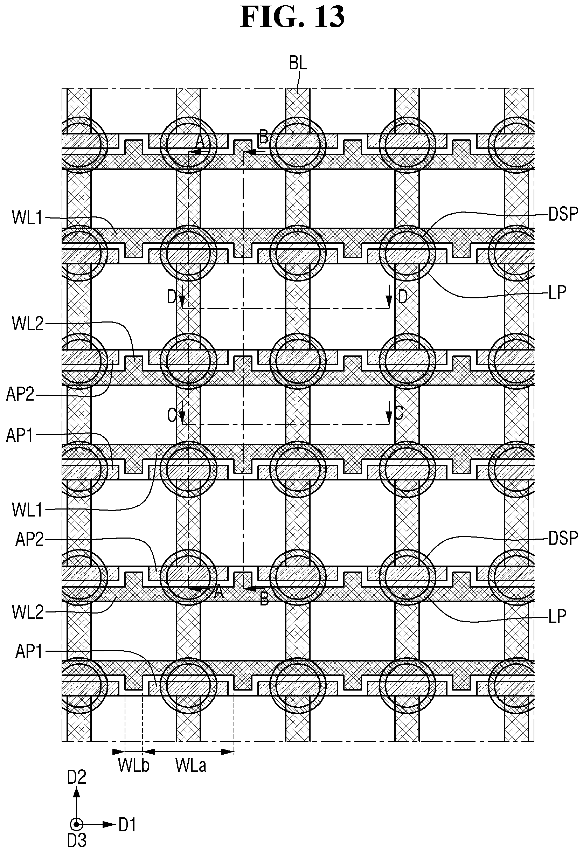

FIGS. 13 to 16 are diagrams for illustrating a semiconductor memory device according to some embodiments. For convenience of description, the following descriptions are based on differences thereof from those set forth with reference to FIG. 1 to FIG. 8.

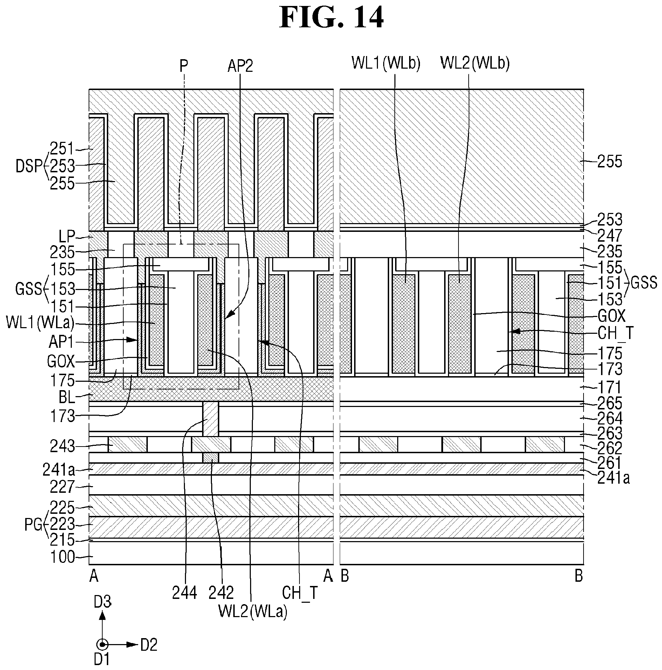

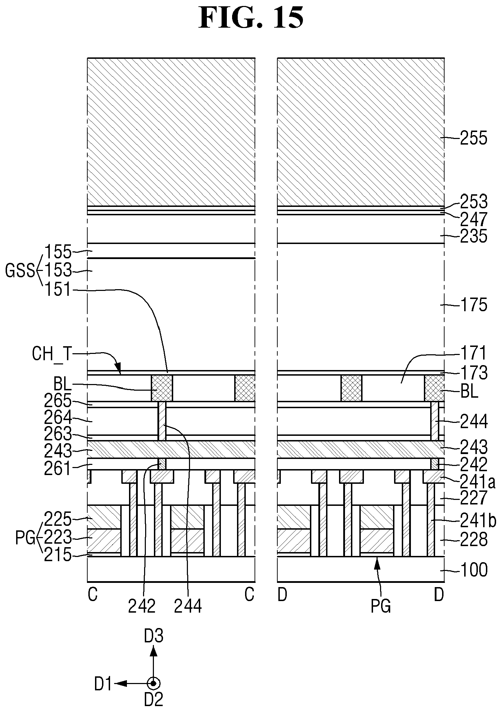

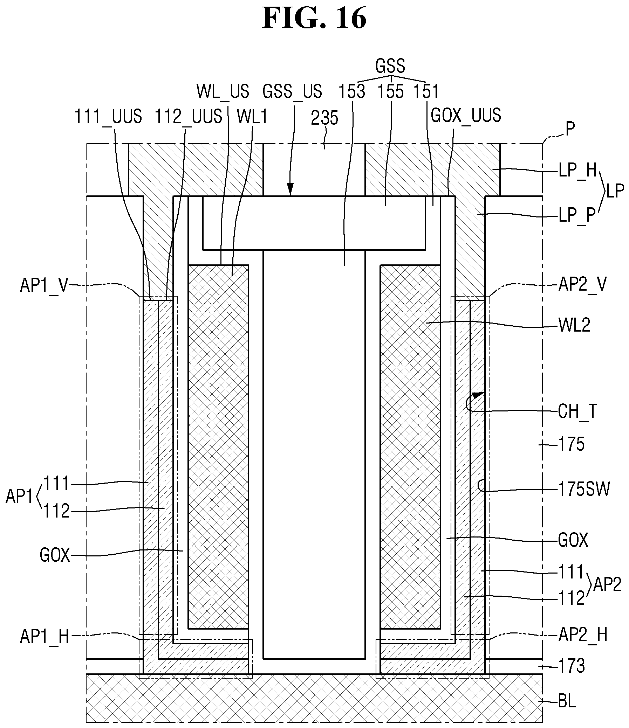

For reference, FIG. 13 is a layout diagram for illustrating the semiconductor memory device according to some embodiments. FIG. 14 is a cross-sectional view taken along A - A and B - B of FIG. 13. FIG. 15 is a cross-sectional view taken along C - C and D - D of FIG. 13. FIG. 16 is an enlarged view of region P of FIG. 14.

Referring to FIG. 13 to FIG. 16, in the semiconductor memory device according to some embodiments, the first channel pattern AP1 and the second channel pattern AP2 spaced apart from each other in the second direction D2 may not be connected to each other in the channel trench CH_T.

Each of the first channel pattern AP1 and the second channel pattern AP2 may include the first metal oxide pattern 111 and the second metal oxide pattern 112.

The first channel pattern AP1 may include a horizontal portion AP1_H extending along the upper surface of the bit-line BL and a vertical portion AP1_V extending along the sidewall 175SW of the protruding insulating pattern. The vertical portion AP1_V of the first channel pattern may protrude from the horizontal portion AP1_H of the first channel pattern in the third direction D3.

The second channel pattern AP2 may include a horizontal portion AP2_H extending along the upper surface of the bit-line BL and a vertical portion AP2_V extending along the sidewall 175SW of the protruding insulating pattern. The vertical portion AP2 _V of the second channel pattern may protrude from the horizontal portion AP2_H of the second channel pattern in the third direction D3.

The gate isolation pattern GSS may contact the bit-line BL. The horizontal portion AP2_H of the second channel pattern and the horizontal portion AP1_H of the first channel pattern may be spatially separated from each other by the gate isolation pattern GSS. The gate isolation liner 151 may contact the bit-line BL.

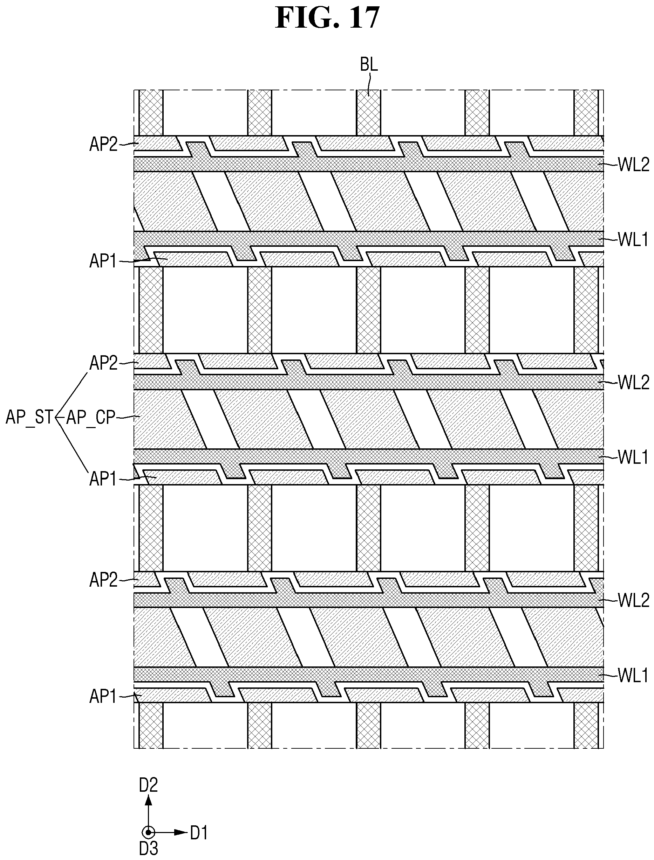

FIGS. 17 to 20 are diagrams for illustrating semiconductor memory devices according to some embodiments, respectively. For convenience of description, the following descriptions are based on differences thereof from those set forth with reference to FIG. 1 to FIG. 8.

Referring to FIG. 17, in the semiconductor memory device according to some embodiments, the first channel pattern AP1 and the second channel pattern AP2 may be alternately arranged in an oblique direction with respect to the first direction D1 and the second direction D2. In this regard, the oblique direction may be parallel to an upper surface of the substrate 100.

The channel structure AP_ST may be formed by being twisted in the oblique direction. In a plan view, each of the first channel pattern AP1, the second channel pattern AP2, and the connection channel pattern AP_CP may have a parallelogram shape or a rhombus shape.

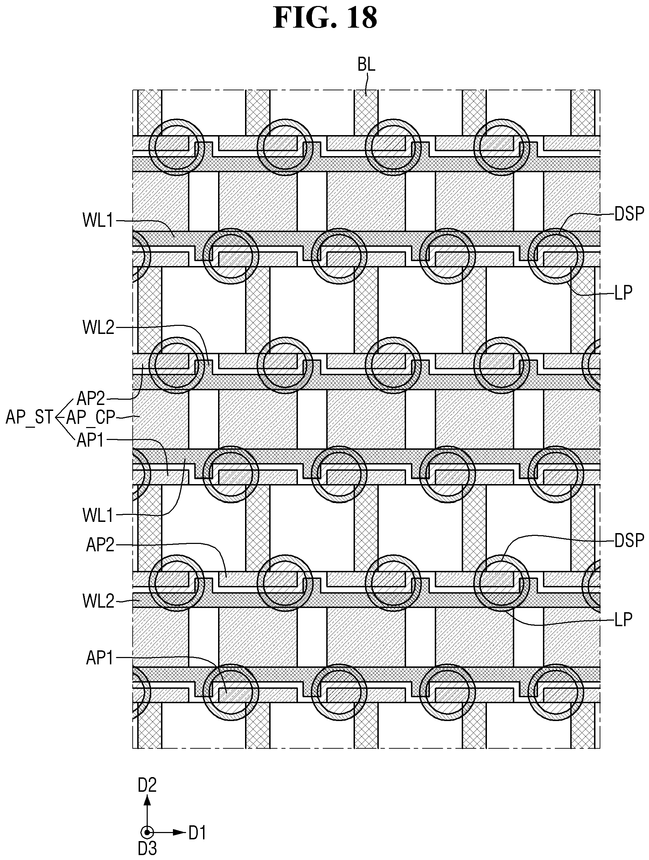

Referring to FIG. 18, in the semiconductor memory device according to some embodiments, the landing pads LP and the data storage patterns DSP may be arranged in a zigzag form or a honeycomb form in a plan view.

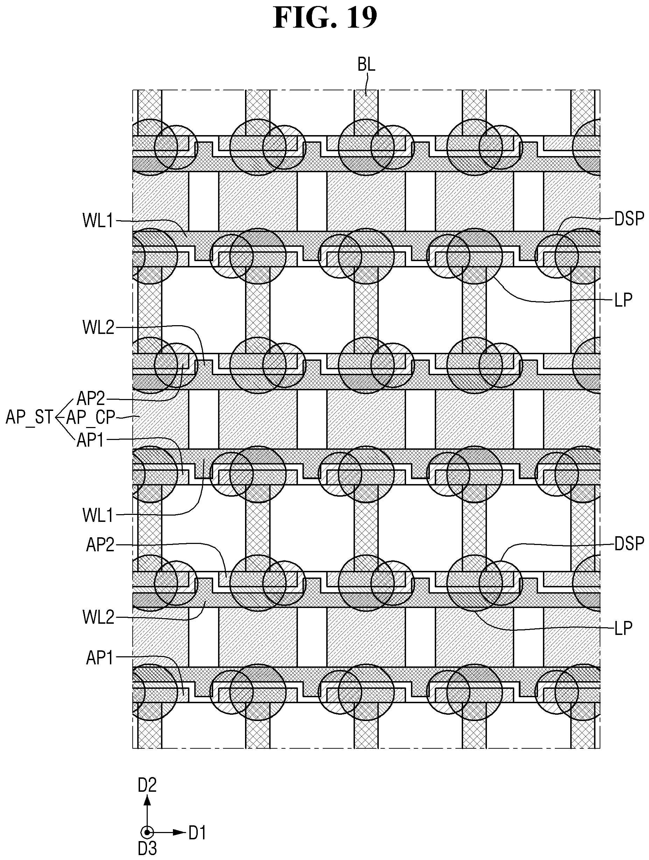

Referring to FIG. 19, in the semiconductor memory device according to some embodiments, data storage patterns DSP may be misaligned with the landing pads LP in a plan view.

Each of the data storage patterns DSP may contact a portion of each of the landing pads LP.

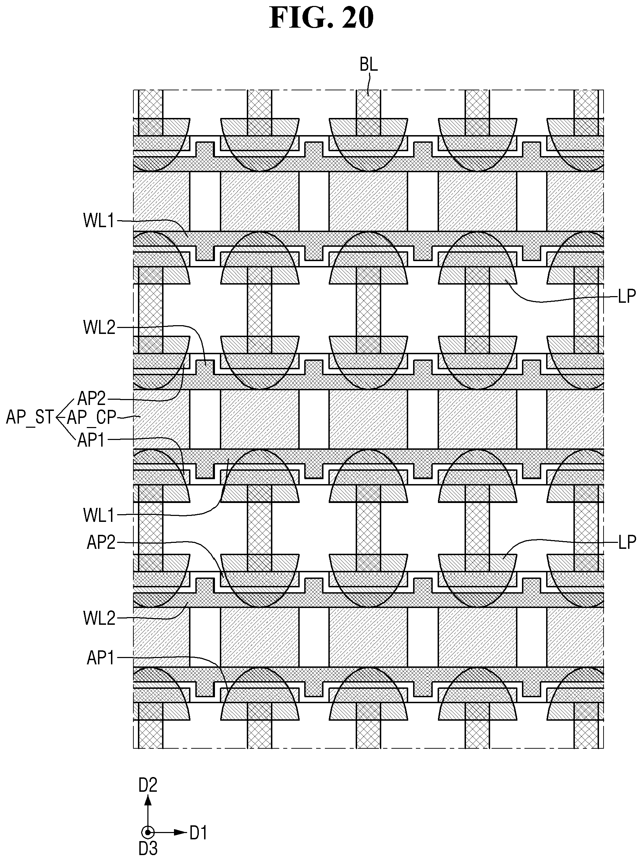

Referring to FIG. 20, in the semiconductor memory device according to some embodiments, each of the landing pads LP on each of the first channel pattern AP1 and the second channel pattern AP2 may have a semi-circular shape or a semi-oval shape in a plan view.

In a plan view, the landing pads LP may be arranged symmetrically to each other.

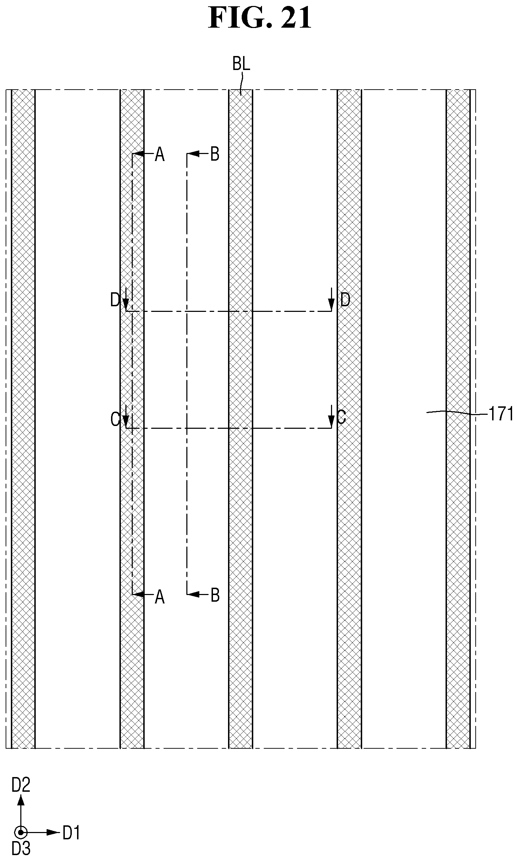

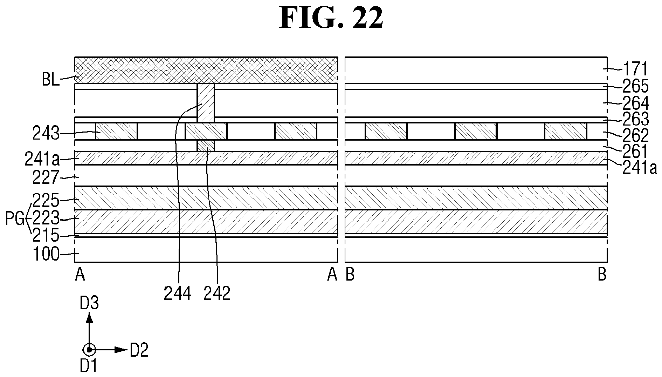

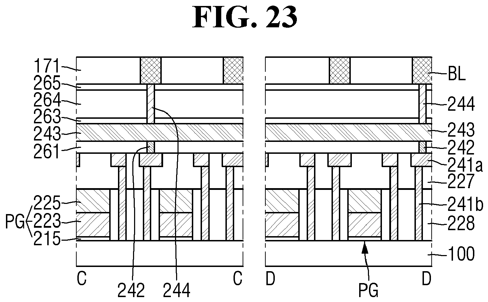

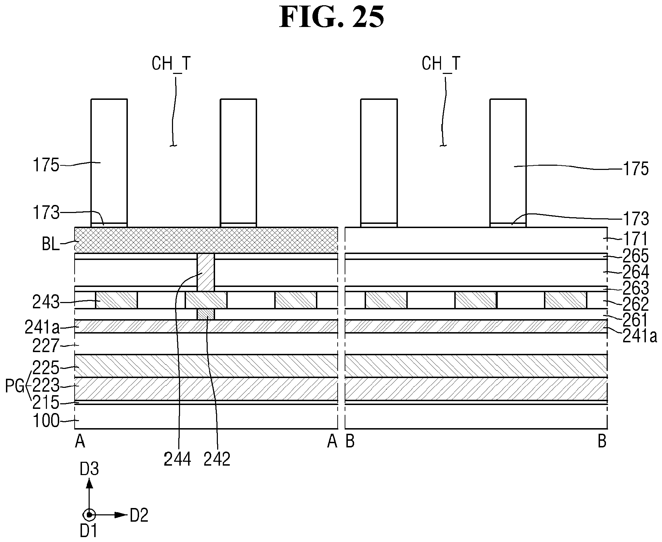

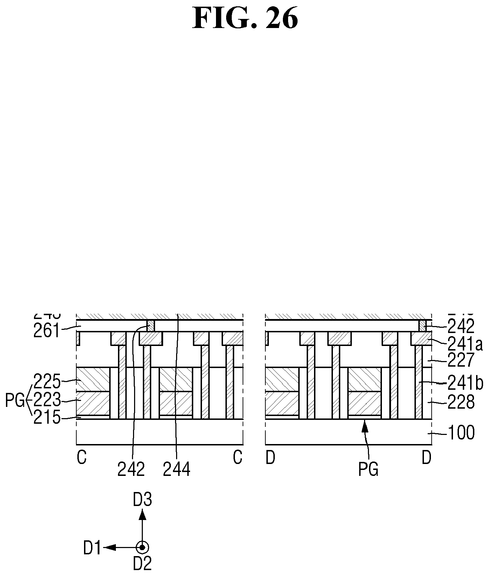

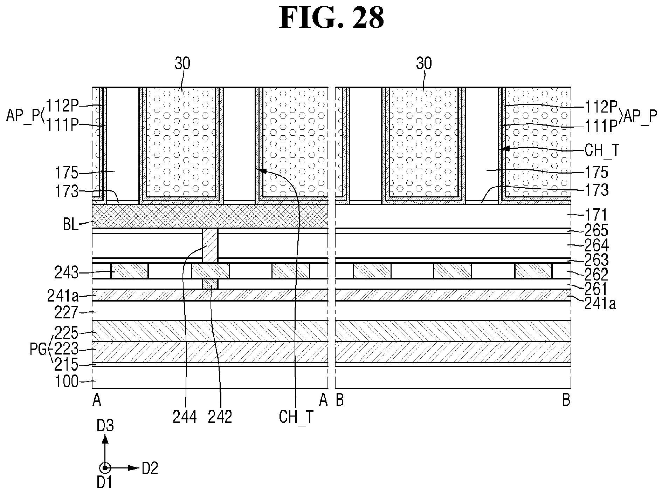

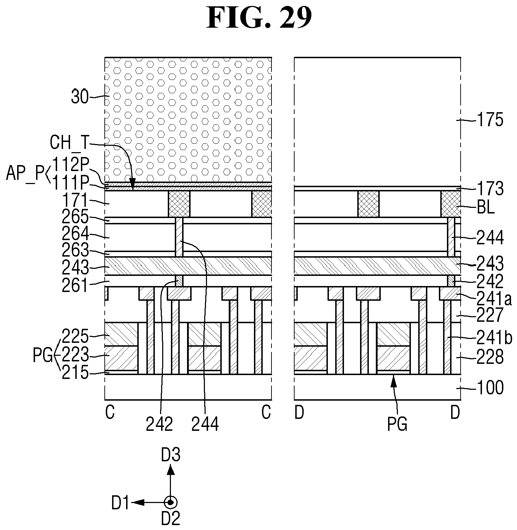

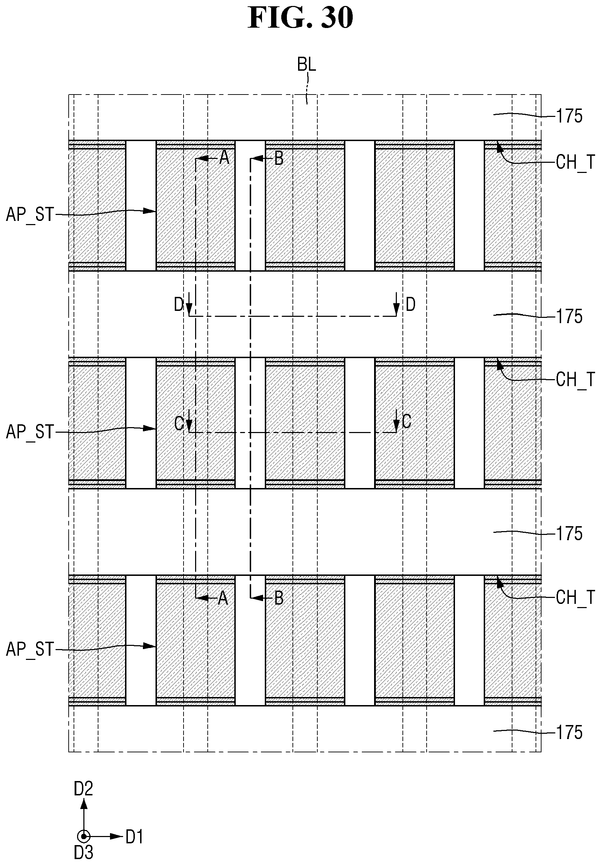

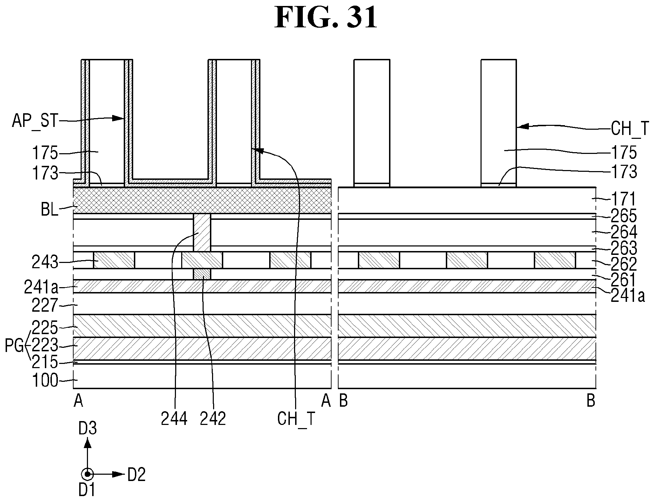

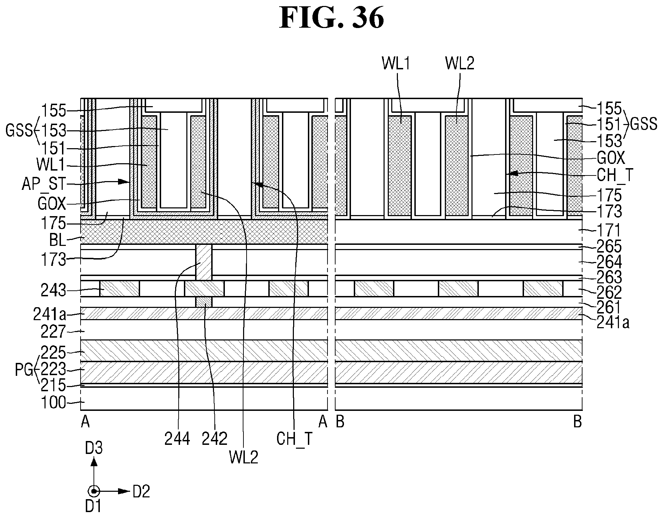

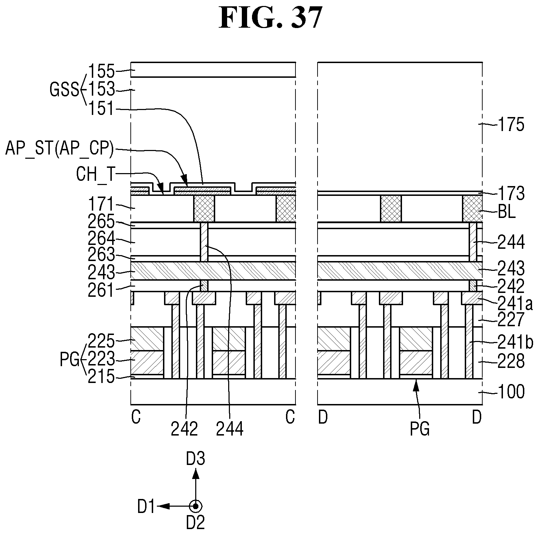

FIGS. 21 to 37 are diagrams for illustrating stages in a method for manufacturing a semiconductor memory device according to some embodiments.

Referring to FIG. 21 to FIG. 23, the peripheral gate structure PG may be formed on the substrate 100.

The first peripheral wiring line 241a and the peripheral contact plug 241b may be formed on the substrate 100.

The peripheral upper insulating films 261, 262, 263, 264, and 265 may be sequentially formed on the first peripheral wiring line 241a and the peripheral contact plug 241b. The second peripheral wiring line 243, the peripheral via plug 242, and the cell connection plug 244 may be formed in the peripheral upper insulating films 261, 262, 263, 264, and 265.

Subsequently, the bit-lines BL may be formed on the fifth peripheral upper insulating film 265. The bit-line BL may extend lengthwise in the second direction D2 on the substrate 100. The cell lower insulating film 171 may be formed on the fifth peripheral upper insulating film 265. The cell lower insulating film 171 may expose the upper surface of the bit-line BL.

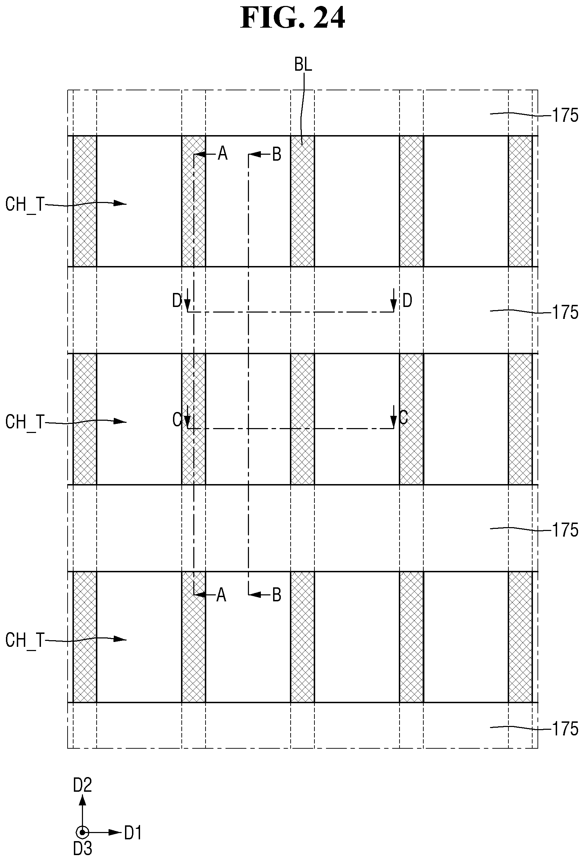

Referring to FIG. 24 to FIG. 26, the protruding insulating pattern 175 may be formed on the substrate 100. In an implementation, the protruding insulating pattern 175 may be formed on the bit-line BL and the cell lower insulating film 171.

In an implementation, the cell lower etch stop film 173 may be formed between the protruding insulating pattern 175 and the cell lower insulating film 171.

The protruding insulating pattern 175 may include a plurality of channel trenches CH_T extending in the first direction D1. The channel trenches CH_T may intersect the bit-lines BL. The channel trenches CH_T may expose the bit-lines BL.

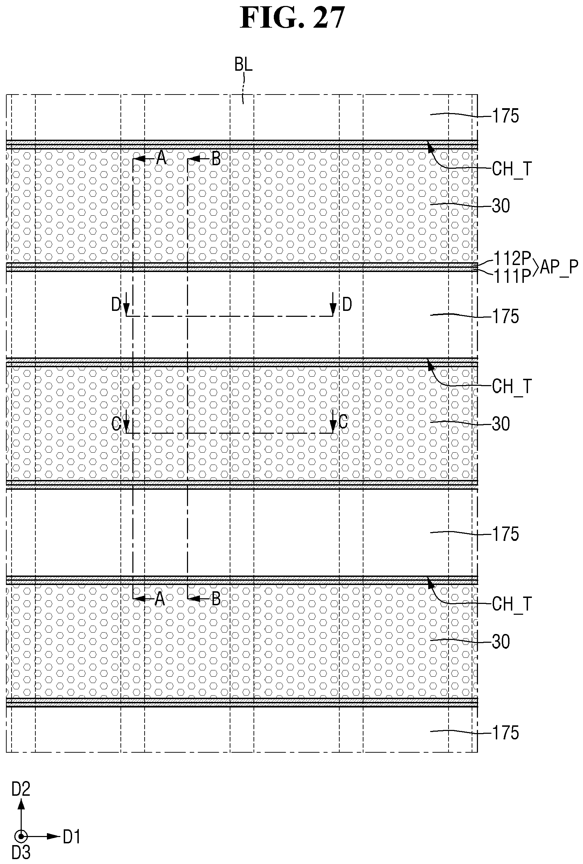

Referring to FIG. 27 to FIG. 29, a pre-channel structure AP_P may be formed along the sidewall and the lower surface of the channel trench CH_T.

The pre-channel structure AP_P may be in contact with the bit-line BL exposed by the channel trench CH_T. The pre-channel structure AP_P may not be formed on the upper surface of the protruding insulating pattern 175.

The pre-channel structure AP_P may include a first pre-metal oxide pattern 111P and a second pre-metal oxide pattern 112P sequentially on the bit-line BL.

Subsequently, a sacrificial film 30 may be formed on the pre-channel structure AP_P. The sacrificial film 30 may fill the channel trench CH_T. The sacrificial film 30 may include, e.g., an insulating material or a silicon oxide that may be formed using a SOG (Spin On Glass) scheme.

Referring to FIG. 27 to FIG. 32, the channel structure AP_ST extending along the sidewall and the lower surface of the channel trench CH_T may be formed by patterning the pre-channel structure AP_P.

In an implementation, a channel isolation mask may be formed on the sacrificial film 30 and the protruding insulating pattern 175. Using the channel isolation mask, a portion of the sacrificial film 30 may be removed. A portion of the pre-channel structure AP_P may be exposed as the portion of the sacrificial film 30 is removed.

Using an etching process, the exposed portion of the pre-channel structure AP_P may be removed. Thus, the channel structure AP_ST may be formed in the channel trench CH_T.

Subsequently, the sacrificial film 30 may be removed from the channel trench CH_T.

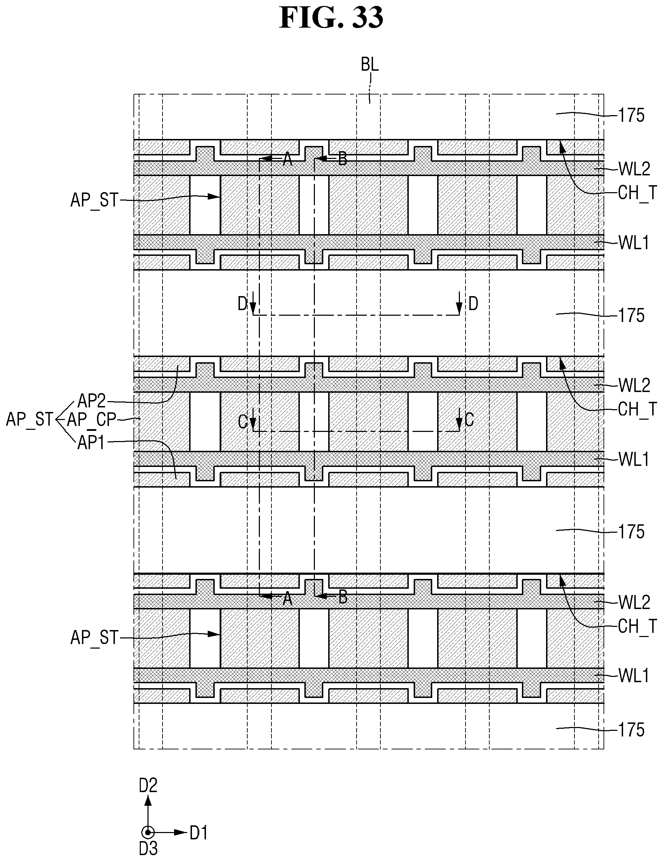

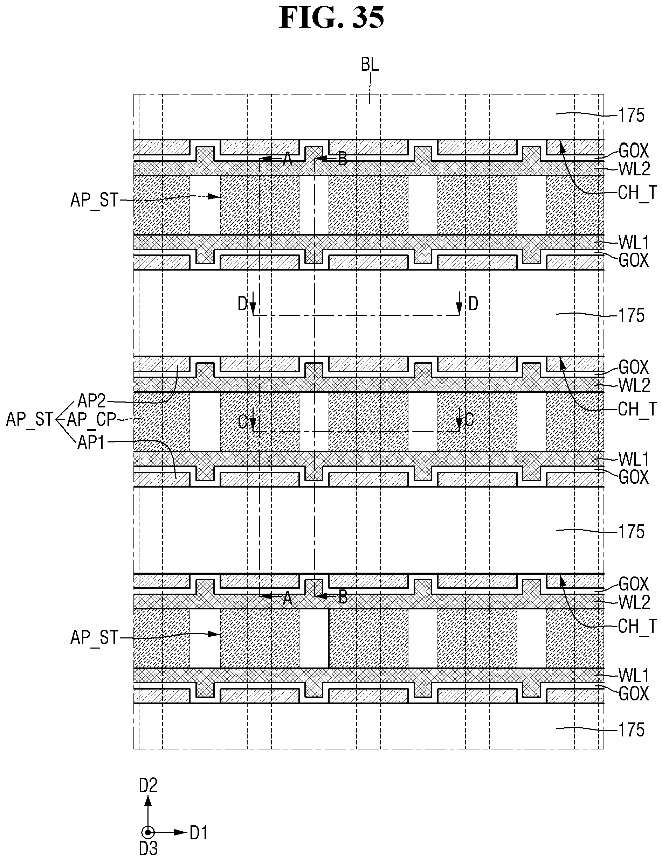

Hereinafter, the channel structure AP_ST of FIG. 33 and FIG. 35 illustrating a plan view is illustrated as being embodied as a single film.

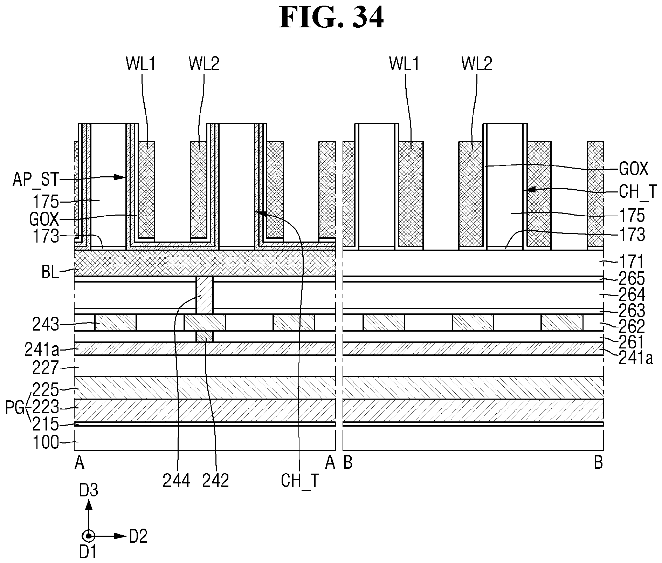

Referring to FIG. 33 and FIG. 34, the gate insulating film GOX may be formed on the channel structure AP_ST.

The gate insulating film GOX may be formed along a profile of the channel structure AP_ST. In an area where the channel structure AP_ST is not formed, the gate insulating film GOX may be formed along the sidewall of the protruding insulating pattern 175. The gate insulating pattern GOX may be formed using, e.g., physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD) processes.

Subsequently, the first word-line WL1 and the second word-line WL2 may be formed on the gate insulating pattern GOX. The first word-line WL1 and the second word-line WL2 may be formed along the sidewall of the channel trench CH_T.

Forming the first word-line WL1 and the second word-line WL2 may include depositing a gate conductive film on the gate insulating pattern GOX and then performing an anisotropic etching process on the gate conductive film.

In the anisotropic etching process on the gate conductive film, a portion of the gate insulating film GOX may be etched. Through this, a portion of the gate insulating film GOX between the first word-line WL1 and the channel structure AP_ST may be separated from a portion of the gate insulating film GOX between the second word-line WL2 and the channel structure AP_ST. In an implementation, in the anisotropic etching process on the gate conductive film, the gate insulating pattern GOX may be used as an etch stop film.

A vertical level of each of the upper surface of the first word-line WL1 and the upper surface of the second word-line WL2 may be lower than that of the upper surface of the protruding insulating pattern 175.

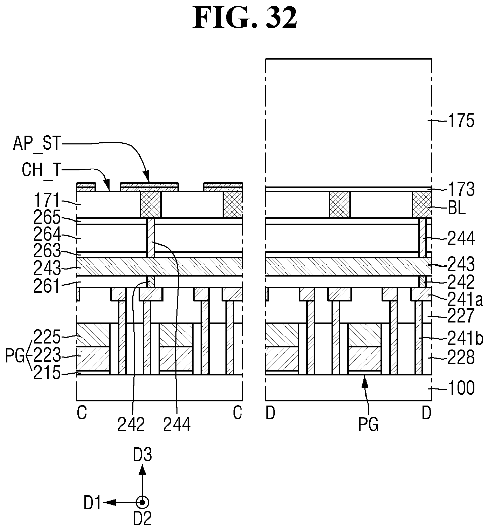

A cross-sectional view taken along C - C and D - D of FIG. 33 may be the same as that of FIG. 32.

Referring to FIG. 35 to FIG. 37, the gate isolation pattern GSS may be formed on the first word-line WL1 and the second word-line WL2. The gate isolation pattern GSS may fill the channel trench CH_T.

More specifically, the gate isolation liner 151 may be formed along a profile of the first word-line WL1 and a profile of the second word-line WL2. The gate isolation liner 151 may also be formed on the upper surface of the protruding insulating pattern 175.

A pre-filling film may be formed on the gate isolation liner 151. The pre-filling film may also be formed on the upper surface of the protruding insulating pattern 175. The gate isolation filling film 153 may be formed on the gate isolation liner 151 by removing a portion of the pre-filling film.

A pre-capping film may be formed on the gate isolation filling film 153. The pre-capping film may also be formed on the upper surface of the protruding insulating pattern 175. The gate isolation capping film 155 may be formed by removing a portion of the pre-capping film. While the gate isolation capping film 155 is being formed, the gate isolation liner 151 and the pre-capping film formed on the upper surface of the protruding insulating pattern 175 may be removed.

Referring back to FIG. 2 and FIG. 3, an uppermost surface of the channel structure AP_ST may be lower than an upper surface of the protruding insulating pattern 175 by removing a portion of the channel structure AP_ST. Subsequently, a pre-landing pad film may be formed on the protruding insulating pattern 175, the gate isolation pattern GSS, and the channel structure AP_ST. The landing pads LP may be formed on the channel structure AP_ST by patterning the pre-landing pad film.

Subsequently, the data storage pattern DSP may be formed on the landing pad LP. The data storage pattern DSP may be connected to the channel structure AP_ST and may be formed on the gate isolation pattern GSS.

By way of summation and review, ultra-expensive equipment may be used for pattern miniaturization, and the integration density of the 2D semiconductor memory devices may be increased, but may still be limited. A semiconductor memory device including a vertical channel transistor in which a channel extends in a vertical direction may be considered.

One or more embodiments may provide a semiconductor memory device including a vertical channel transistor (VCT).

One or more embodiments may provide a semiconductor memory device with improved integration density and electrical properties.

One or more embodiments may provide a method for manufacturing a semiconductor memory device with improved integration density and electrical properties.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor memory device, comprising:
a substrate;
a bit-line on the substrate, the bit-line extending in a first direction;
a first channel pattern on the bit-line;
a second channel pattern on the bit-line and spaced apart from the first channel pattern in the first direction;
a first word-line between the first channel pattern and the second channel pattern and extending in a second direction that intersects the first direction;
a second word-line between the first channel pattern and the second channel pattern, the second word-line extending in the second direction and being spaced apart from the first word-line in the first direction;
a first capacitor on and connected to the first channel pattern; and
a second capacitor on and connected to the second channel pattern,
wherein:
the first channel pattern and the second channel pattern each include a first metal oxide pattern and a second metal oxide pattern sequentially on the bit-line,
at least one of the first metal oxide pattern and the second metal oxide pattern includes an amorphous metal oxide, and
a composition of the first metal oxide pattern is different from a composition of the second metal oxide pattern.

2. The device as claimed in claim 1, wherein:
the first word-line includes first portions and second portions alternately disposed in the second direction, and
a width of the first portions of the first word-line in the first direction is smaller than a width of the second portions of the first word-line in the first direction.

3. The device as claimed in claim 2, wherein:
the first channel pattern is closer to the first word-line than it is to the second word-line, and
the first channel pattern is between adjacent second portions of the first word-line in the second direction.

4. The device as claimed in any preceding claim, wherein each of the first metal oxide pattern and the second metal oxide pattern includes IGZO, impurity-doped IZO, InO, ZnO, GaO, SnO, AZO, or ITO.

5. The device as claimed in any preceding claim, wherein:
the first metal oxide pattern is between the second metal oxide pattern and the bit-line,
each of the first metal oxide pattern and the second metal oxide pattern includes IGZO, and
a ratio of a content of indium (In) to a content of gallium (Ga) in the first metal oxide pattern is smaller than a ratio of a content of indium (In) to a content of gallium (Ga) in the second metal oxide pattern.

6. The device as claimed in any preceding claim, further comprising a gate insulating film between the first channel pattern and the first word-line,
wherein a height from the bit-line to an uppermost surface of the gate insulating film is larger than a height from the bit-line to an uppermost surface of the first channel pattern.

7. The device as claimed in any preceding claim, wherein:
the first channel pattern and the second channel pattern each further include a third metal oxide pattern between the first metal oxide pattern and the bit-line, and
the third metal oxide pattern includes an amorphous metal oxide.

8. The device as claimed in any preceding claim, further comprising a gate isolation pattern on the bit-line, the gate isolation pattern separating the first word-line and the second word-line,
wherein:
the first channel pattern and the second channel pattern are connected to each other by a connection channel pattern, and
the gate isolation pattern is on the connection channel pattern.

9. The device as claimed in any of claims 1 to 7, further comprising a gate isolation pattern on the bit-line, the gate isolation pattern separating the first word-line and the second word-line,
wherein the gate isolation pattern is in contact with the bit-line.

10. The device as claimed in any preceding claim, further comprising a protruding insulating pattern on the bit-line,
wherein the first channel pattern includes a vertical portion extending along a sidewall of the protruding insulating pattern and a horizontal portion extending along an upper surface of the bit-line.

11. The device as claimed in any preceding claim, wherein the second metal oxide pattern includes CAAC (c-axis aligned crystalline) IGZO.
